# EUROPEAN PATENT APPLICATION

(11) **EP 4 601 443 A1**
(43) Date of publication of application: **13.08.2025**
(21) Application number: 25153098.6
(22) Date of filing: 21.01.2025
(51) Int. Cl.: H10K 59/80, H10K 59/38

(54) **DISPLAY DEVICE INCLUDING LIGHT BLOCKING LAYERS**

(30) Priority: 08.02.2024 KR 20240019943
(71) Applicant: Samsung Display Co., Ltd., Yongin-si, Gyeonggi-do 17113 (KR)
(72) Inventor: GIL, Elly, Yongin-si, Gyeonggi-do (KR); JUNG, Soon Il, Yongin-si, Gyeonggi-do (KR); CHOI, Beohm Rock, Yongin-si, Gyeonggi-do (KR)
(74) Representative: Gulde & Partner

(57) **Abstract**

A display device includes a display area in which a plurality of pixels, each including a plurality of pixel electrodes spaced apart from each other, are disposed. A first light blocking layer is disposed in the display area and includes a plurality of holes overlapping the plurality of pixel electrodes. A plurality of color filters is disposed on the first light blocking layer and respectively corresponds to the plurality of holes. A second light blocking layer is disposed on the color filter and corresponds to the pixel electrodes of some of the plurality of pixels. The second light blocking layer surrounds the pixel electrodes of some of the plurality of pixels in a plan view and includes a plurality of light blocking patterns having different widths.

## Description

### TECHNICAL FIELD

The present disclosure relates to a display device and, more specifically, to a display device including light blocking layers.

### DISCUSSION OF THE RELATED ART

With the advance of an information-oriented society, increased demands are placed on display devices for displaying images. For example, display devices are employed in various electronic devices such as smartphones, digital cameras, laptop computers, navigation devices, and smart televisions. Display devices may be flat panel display devices such as a liquid crystal display (LCD) devices, field emission display devices, and organic light emitting diode (OLED) display devices. Among the flat panel display devices, in the light emitting type of display devices, since each pixel of a display panel includes a light emitting element capable of emitting light by itself, an image can be displayed without a backlight unit providing light to the display panel.

### SUMMARY

The present disclosure relates to a display device comprising a display area, which includes a plurality of pixels, each including a plurality of pixel electrodes spaced apart from each other. A first light blocking layer is disposed in the display area and includes a plurality of holes overlapping the plurality of pixel electrodes. A plurality of color filters is disposed on the first light blocking layer and respectively correspond to the plurality of holes, i.e. each color filter of the plurality of color filters covering one corresponding hole of the plurality of holes of the first light blocking layer. A second light blocking layer is disposed on the color filter and corresponds to the pixel electrodes of some of the plurality of pixels. The second light blocking layer surrounds the pixel electrodes of some of the plurality of pixels in a plan view and includes a plurality of light blocking patterns having different widths.

The display device prevents the light leakage phenomenon of light emitted from the light emitting elements including the specific pixels and may reduce the intensity of reflected light caused by the external light.

In a preferred embodiment, at least one of the plurality of the pixels comprises a first pixel electrode and a second pixel electrode having a smaller diameter than the first pixel electrode, the second light blocking layer comprises a first light blocking pattern corresponding to the first pixel electrode , and a second light blocking pattern corresponding to the second pixel electrode, and a separation distance between an outer side of the first pixel electrode and an inner side of the first light blocking pattern is different from a separation distance between an outer side of the second pixel electrode and an inner side of the second light blocking pattern.

In one or more preferred embodiments, a width of the first light blocking pattern is smaller than a width of the second light blocking pattern.

In one or more preferred embodiments, the separation distance between the outer side of the first pixel electrode and the inner side of the first light blocking pattern is smaller than the separation distance between the outer side of the second pixel electrode and the inner side of the second light blocking pattern.

In one or more preferred embodiments, the separation distance between the outer side of the first pixel electrode and the inner side of the first light blocking pattern is in a range from 1 µm to 3 µm.

In one or more preferred embodiments, a distance between a center of the first pixel electrode and the inner side of the first light blocking pattern is equal to a distance between a center of the second pixel electrode and the inner side of the second light blocking pattern.

In one or more preferred embodiments, an outer radius from a center of the first pixel electrode to an outer side of the first light blocking pattern is smaller than an outer radius from a center of the second pixel electrode to an outer side of the second light blocking pattern.

In one or more preferred embodiments, the pixel comprises a third pixel electrode having a larger diameter than that of the first pixel electrode, the second light blocking layer comprises a third light blocking pattern corresponding to the third pixel electrode, and a separation distance between an outer side of the third pixel electrode and an inner side of the third light blocking pattern is smaller than the separation distance between the outer side of the first pixel electrode and the inner side of the first light blocking pattern.

Preferably, in the embodiment above, a width of the third light blocking pattern is smaller than a width of the first light blocking pattern.

In another preferred embodiment, in the first pixel electrode, a length in a first direction is equal to a length in a second direction that is perpendicular to the first direction, and in the second pixel electrode, a length in the first direction is greater than a length in the second direction.

Preferably, in the embodiment above, in the second light blocking pattern, a length in the first direction is greater than a length in the second direction; and/or in the second light blocking pattern, a width of a side extending in the first direction is larger than a width of a side extending in the second direction.

In another preferred embodiment, the plurality of pixels comprise a first pixel in which the second light blocking layer is not disposed, and a second pixel in which the light blocking patterns respectively correspond to the pixel electrodes.

Preferably, in the embodiment above, a diameter of the hole of the first light blocking layer in the first pixel is larger than a diameter of the hole of the first light blocking layer in the second pixel.

Further preferred, in the embodiments above, a difference between a diameter of the first pixel electrode and the diameter of the hole of the first light blocking layer in the first pixel is greater than a difference between a diameter of the first pixel electrode and the diameter of the hole of the first light blocking layer in the second pixel.

In one or more preferred embodiments, the display device further comprises a display panel, the display panel comprising: a substrate on which a first pixel and a second pixel of the plurality of pixels are disposed; an encapsulation layer disposed on the pixel electrodes; the first light blocking layer disposed on the encapsulation layer; a passivation layer disposed on the color filters and the first light blocking layer ; the second light blocking layer disposed on the passivation layer in the second pixel and comprising the plurality of light blocking patterns forming a plurality of transmission portions respectively overlapping the pixel electrodes of the second pixel; and an overcoat layer disposed on the second light blocking layer.

### BRIEF DESCRIPTION OF THE DRAWINGS

The above and other aspects and features of the present disclosure will become more apparent by describing in detail some embodiments thereof with reference to the attached drawings, in which:
FIG. 1 is a schematic perspective view of an electronic device according to an embodiment of the present disclosure;
FIG. 2 is a perspective view illustrating a display device included in an electronic device according to an embodiment of the present disclosure;
FIG. 3 is a cross-sectional view of the display device of FIG. 2 viewed from the side;
FIG. 4 is a plan view of the display device according to an embodiment of the present disclosure illustrating the spatial layout of pixel electrodes in the display area of the display device;
FIG. 5 is a plan view illustrating the spatial layout of a pixel electrode, a first light blocking layer, and color filters in a display area of a display device according to an embodiment of the present disclosure;
FIG. 6 is a plan view of the display device according to an embodiment of the present disclosure showing the spatial layout of a pixel electrode and a second light blocking layer in the display area of the display device;
FIG. 7 is a schematic diagram illustrating light emitting pixels according to an emission mode of a display device according to an embodiment of the present disclosure;
FIG. 8 is a cross-sectional view taken along line X1-X1' of FIGS. 5 and 6;
FIG. 9 is a cross-sectional view taken along line X2-X2' of FIGS. 5 and 6;
FIG. 10 is a cross-sectional view taken along lines X3-X3' and X4-X4' of FIGS. 5 and 6;
FIG. 11 is a diagram illustrating the relative position of a pixel electrode and a first light blocking layer disposed in one pixel of a display device according to an embodiment of the present disclosure;
FIG. 12 is a diagram illustrating the relative position of a pixel electrode and a second light blocking layer disposed in one pixel of a display device according to an embodiment of the present disclosure;
FIG. 13 is an example diagram illustrating a relative position of a second light blocking layer and an emission direction of light emitted from a pixel electrode of a display device;
FIG. 14 is a plan view of the position of pixel electrodes in a display area of a display device according to an embodiment of the present disclosure;
FIG. 15 is a plan view illustrating the spatial layout of a pixel electrode, a first light blocking layer, and color filters in a display area of the display device of FIG. 14;
FIG. 16 is a plan view showing the spatial layout of a pixel electrode and a second light blocking layer in the display area of the display device of FIG. 14;
FIG. 17 is a diagram illustrating the relative position of a pixel electrode and a second light blocking layer in the display device of FIG. 14; and
FIG. 18 is a schematic cross-sectional view of a display device according to an embodiment of the present disclosure.

### DETAILED DESCRIPTION OF THE EMBODIMENTS

The present invention will now be described more fully hereinafter with reference to the accompanying drawings, in which example embodiments of the invention are shown. This invention may, however, be embodied in different forms and should not necessarily be construed as limited to the embodiments set forth herein. Rather, these embodiments are provided so that this disclosure will be thorough and complete, and will filly convey the scope of the invention to those skilled in the art.

It will also be understood that when a layer is referred to as being "on" another layer or substrate, it can be directly on the other layer or substrate, or intervening layers may also be present. The same reference numbers may indicate the same components throughout the specification and the drawings. In the attached figures, while some elements may be drawn to scale, such that the relative lengths, thicknesses, and angles can be inferred therefrom, it is to be understood that the present invention is not necessarily limited to the relative lengths, thicknesses, and angles shown. Changes to these values may be made within the spirit and scope of the present disclosure, for example, to allow for manufacturing limitations and the like.

Although the terms "first", "second", etc. may be used herein to describe various elements, these elements, should not necessarily be limited by these terms. These terms may be used to distinguish one element from another element. Thus, a first element discussed below may be termed a second element without departing from teachings of one or more embodiments. The description of an element as a "first" element might not require or imply the presence of a second element or other elements. The terms "first", "second", etc. may also be used herein to differentiate different categories or sets of elements. For conciseness, the terms "first", "second", etc. may represent "first-category (or first-set)", "second-category (or second-set)", etc., respectively.

Hereinafter, embodiments will be described with reference to the accompanying drawings.

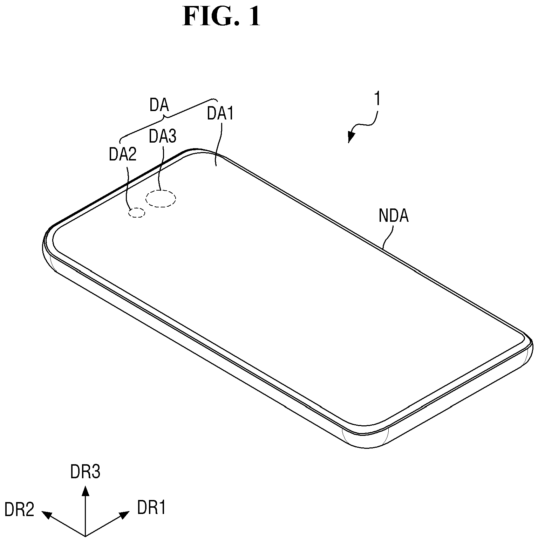

FIG. 1 is a schematic perspective view of an electronic device according to an embodiment of the present disclosure.

Referring to FIG. 1, an electronic device 1 displays a moving image or a still image. The electronic device 1 may refer to any electronic device providing a display screen. Examples of the electronic device 1 may include a television, a laptop computer, a computer monitor, a digital billboard, an Internet-of-Things device, a mobile phone, a smartphone, a tablet computer, an electronic watch, a smart watch, a watch phone, a head-mounted display, a mobile communication terminal, an electronic notebook, an electronic book, a portable multimedia player (PMP), a navigation device, a portable game console, a digital camera, a camcorder and the like, which provide a display screen.

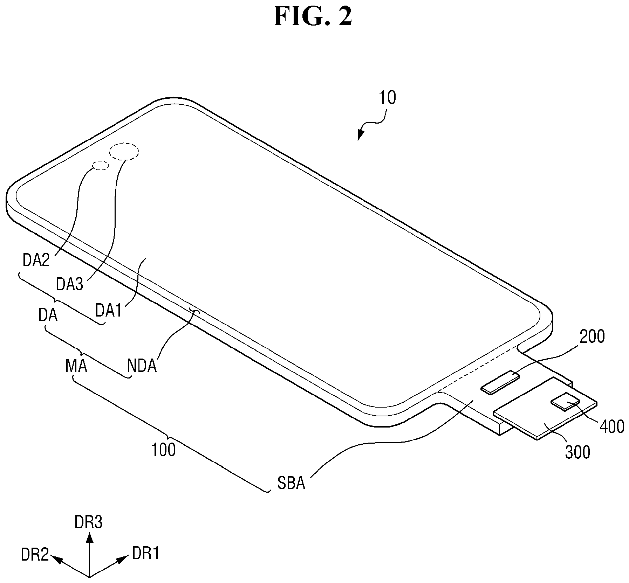

The electronic device 1 may include a display device 10 in FIG. 2 providing a display screen. Examples of the display device may include an inorganic light emitting diode (OLED) display device, an organic light emitting display device, a quantum dot light emitting display device, a plasma display device and a field emission display device. In the following description, a case where an organic light emitting diode (OLED) display device is applied as a display device will be exemplified, but the present disclosure is not necessarily limited thereto, and other display devices may be applied within the same scope of technical spirit.

The shape of the electronic device 1 may be variously modified. For example, the electronic device 1 may have a shape such as a rectangular shape elongated in a horizontal direction, a rectangular shape elongated in a vertical direction, a square shape, a quadrilateral shape with rounded corners (vertices), other polygonal shapes and a circular shape. The shape of a display area DA of the electronic device 1 may also be similar to the overall shape of the electronic device 1. FIG. 1 illustrates the electronic device 1 having a rectangular shape elongated in a second direction DR2.

The electronic device 1 may include a display area DA and a non-display area NDA. The display area DA is an area where an image can be displayed, and the non-display area NDA is an area where an image is not displayed. The display area DA may also be referred to as an active region, and the non-display area NDA may also be referred to as a non-active region. The display area DA may substantially occupy the center of the electronic device 1.

The display area DA may include a first display area DA1, a second display area DA2, and a third display area DA3. The second display area DA2 and the third display area DA3 are areas in which components for adding various functions to the electronic device 1 are disposed, and the second display area DA2 and the third display area DA3 may correspond to a component area.

FIG. 2 is a perspective view illustrating a display device included in an electronic device according to an embodiment of the present disclosure.

Referring to FIG. 2, the electronic device 1, according to an embodiment of the present disclosure, may include a display device 10. The display device 10 may provide an image displayed by the electronic device 1. The display device 10 may have a planar shape similar to the shape of the electronic device 1. For example, the display device 10 may have a shape similar to a rectangular shape having a pair of short side extending in a first direction DR1 and a pair of long side extending in a second direction DR2. The edge where the short side in the first direction DR1 and the long side in the second direction DR2 meet may be rounded to have a desired degree of curvature, but is not necessarily limited thereto and may be formed at a right angle. The planar shape of the display device 10 is not necessarily limited to a quadrilateral shape, and may be formed in a shape similar to another polygonal shape, a circular shape, or elliptical shape.

The display device 10 may include a display panel 100, a display driver 200, a circuit board 300, and a touch driver 400.

The display panel 100 may include a main region MA and a sub-region SBA.

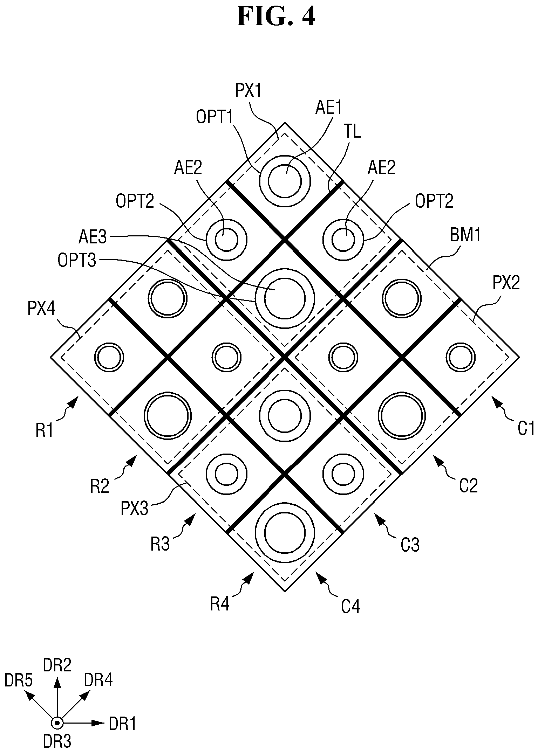

The main region MA may include the display area DA including pixels PX1, PX2, PX3, and PX4 (see FIG. 4) that display an image, and the non-display area NDA disposed around the display area DA. The display area DA may be disposed in the center of the main region MA, and the non-display area NDA may surround the display area DA. The display area DA may include the first display area DA1, the second display area DA2, and the third display area DA3. The display area DA may emit light from a plurality of emission areas or a plurality of opening areas. For example, the display panel 100 may include a pixel circuit including switching elements, a pixel defining layer defining an emission area or an opening area, and a self-light emitting element.

For example, the self-light emitting element may include an organic light emitting diode (LED) including an organic light emitting layer, a quantum dot LED including a quantum dot light emitting layer, an inorganic LED including an inorganic semiconductor, and/or a micro LED, but is not necessarily limited thereto.

The non-display area NDA may be an area outside the display area DA. The non-display area NDA may be defined as an edge area of the main region MA of the display panel 100. The non-display area NDA may include a gate driver that supplies gate signals to the gate lines, and fan-out lines that connect the display driver 200 to the display area DA.

The sub-region SBA may be a region extending from one side of the main region MA. The sub-region SBA may include a flexible material which can be bent, folded or rolled to a noticeable extent without cracking or otherwise sustaining damage. For example, when the sub-region SBA is bent, the sub-region SBA may overlap the main region MA in a thickness direction (e.g., third direction DR3). The sub-region SBA may include the display driver 200 and a pad portion connected to the circuit board 300. In an embodiment of the present disclosure, the sub-region SBA may be omitted, and the display driver 200 and the pad portion may be disposed in the non-display area NDA.

The display driver 200 may output signals and voltages for driving the display panel 100. The display driver 200 may supply data voltages to data lines. The display driver 200 may supply a power voltage to the power line and may supply a gate control signal to the gate driver. The display driver 200 may be formed as an integrated circuit (IC) and mounted on the display panel 100 by a chip on glass (COG) method, a chip on plastic (COP) method, or an ultrasonic bonding method. For example, the display driver 200 may be disposed in the sub-region SBA, and may overlap the main region MA in the thickness direction by bending of the sub-region SBA. For example, the display driver 200 may be mounted on the circuit board 300.

The circuit board 300 may be attached to the pad portion of the display panel 100 by using an anisotropic conductive film (ACF). Lead lines of the circuit board 300 may be electrically connected to the pad portion of the display panel 100. The circuit board 300 may be a flexible printed circuit board, a printed circuit board, or a flexible film such as a chip on film.

The touch driver 400 may be mounted on the circuit board 300. The touch driver 400 may be connected to a touch sensing unit of the display panel 100. The touch driver 400 may supply a touch driving signal to a plurality of touch electrodes of the touch sensing unit and may sense an amount of change in capacitance between the plurality of touch electrodes. For example, the touch driving signal may be a pulse signal having a predetermined frequency. The touch driver 400 may calculate whether an input is made and input coordinates based on an amount of change in capacitance between the plurality of touch electrodes. The touch driver 400 may be formed as an integrated circuit (IC).

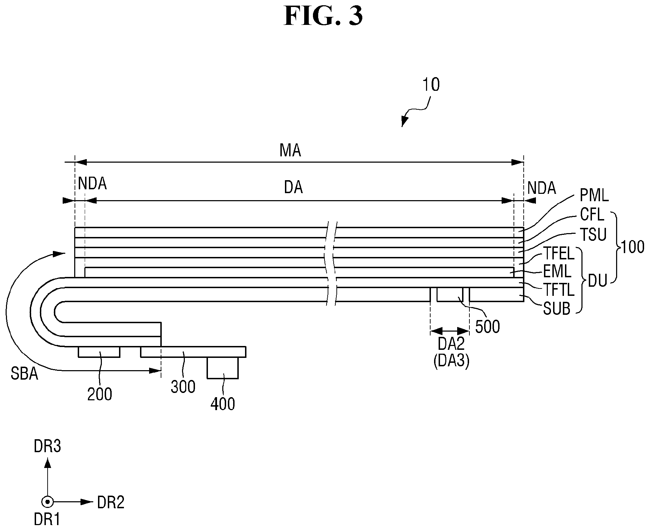

FIG. 3 is a cross-sectional view of the display device of FIG. 2 viewed from the side. FIG. 3 illustrates the sub-region SBA of the display panel 100 in a folded state in the display device 10 of FIG. 2.

Referring to FIG. 3, the display panel 100 may include a display layer DU, a touch sensing layer TSU, a color filter layer CFL, and a light blocking member layer PML. The display layer DU may include a substrate SUB, a thin film transistor layer TFTL, a light emitting element layer EML, and an encapsulation layer TFEL.

The substrate SUB may be a base substrate or a base member. The substrate SUB may be a flexible substrate which can be bent, folded or rolled to a noticeable extent without cracking or otherwise sustaining damage. For example, the substrate SUB may include a polymer resin such as polyimide (PI), but is not necessarily limited thereto. In an embodiment of the present disclosure, the substrate SUB may include a glass or a metal.

The thin film transistor layer TFTL may be disposed on the substrate SUB. The thin film transistor layer TFTL may include a plurality of thin film transistors constituting a pixel circuit of pixels. The thin film transistor layer TFTL may further include gate lines, data lines, power lines, gate control lines, fan-out lines that connect the display driver 200 to the data lines, and lead lines that connect the display driver 200 to the pad portion. Each of the thin film transistors may include a semiconductor region, a source electrode, a drain electrode, and a gate electrode. For example, when the gate driver is formed on one side of the non-display area NDA of the display panel 100, the gate driver may include thin film transistors.

The thin film transistor layer TFTL may be disposed in the display area DA, the non-display area NDA, and the sub-region SBA. Thin film transistors, gate lines, data lines, and power lines of each of the pixels of the thin film transistor layer TFTL may be disposed in the display area DA. Gate control lines and fan-out lines of the thin film transistor layer TFTL may be disposed in the non-display area NDA. The lead lines of the thin film transistor layer TFTL may be disposed in the sub-region SBA.

The light emitting element layer EML may be disposed on the thin film transistor layer TFTL. The light emitting element layer EML may include a plurality of light emitting elements each including a first electrode, a second electrode, and a light emitting layer to emit light, and a pixel defining layer defining pixels. The plurality of light emitting elements of the light emitting element layer EML may be disposed in the display area DA.

In an embodiment of the present disclosure, the light emitting layer may be an organic light emitting layer including an organic material. The light emitting layer may include a hole transporting layer, an organic light emitting layer, and an electron transporting layer. When the first electrode receives a voltage through the thin film transistor of the thin film transistor layer TFTL and the second electrode receives the cathode voltage, holes and electrons may be transferred to the organic light emitting layer through the hole transporting layer and the electron transporting layer, respectively and may be combined with each other to emit light in the organic light emitting layer.

In an embodiment of the present disclosure, the light emitting elements may include a quantum dot light emitting diode including a quantum dot light emitting layer, an inorganic light emitting diode including an inorganic semiconductor, or a micro light emitting diode.

The encapsulation layer TFEL may cover the top surface and the side surface of the light emitting element layer EML, and may protect the light emitting element layer EML. The encapsulation layer TFEL may include at least one inorganic layer and at least one organic layer for encapsulating the light emitting element layer EML.

The touch sensing layer TSU may be disposed on the encapsulation layer TFEL. The touch sensing layer TSU may include a plurality of touch electrodes for sensing a user's touch in a capacitive manner, and touch lines connecting the plurality of touch electrodes to the touch driver 400. For example, the touch sensing layer TSU may sense the user's touch by using a mutual capacitance method or a self-capacitance method.

In an embodiment of the present disclosure, the touch sensing layer TSU may be disposed on a separate substrate disposed on the display layer DU. In this case, the substrate supporting the touch sensing layer TSU may be a base member that encapsulates the display layer DU.

The plurality of touch electrodes of the touch sensing layer TSU may be disposed in a touch sensor area overlapping the display area DA. The touch lines of the touch sensing layer TSU may be disposed in a touch peripheral area that overlaps the non-display area NDA.

The color filter layer CFL may be disposed on the touch sensing layer TSU. The color filter layer CFL may include a plurality of color filters respectively corresponding to the plurality of emission areas. Each of the color filters may selectively transmit light of a specific wavelength and may block or absorb light of a different wavelength. The color filter layer CFL may absorb a part of light coming from the outside of the display device 10 to reduce reflected light due to external light. Accordingly, the color filter layer CFL may prevent color distortion caused by reflection of the external light.

Since the color filter layer CFL is directly disposed on the touch sensing layer TSU, the display device 10 might not require a separate substrate for the color filter layer CFL. Accordingly, the thickness of the display device 10 may be relatively small.

The light blocking member layer PML may be disposed on the color filter layer CFL. The light blocking member layer PML may include light blocking patterns corresponding to specific pixels of the display layer DU. The display device 10 may further include the light blocking member layer PML to control visibility at a specific viewing angle and to provide a privacy protection mode to the user.

In some embodiments, the display device 10 may further include an optical device 500. The optical device 500 may be disposed in the second display area DA2 or the third display area DA3. The optical device 500 may emit or receive light in infrared, ultraviolet, and visible light bands. For example, the optical device 500 may be an optical sensor that detects light incident on the display device 10 such as a proximity sensor, an illuminance sensor, and a camera sensor or an image sensor.

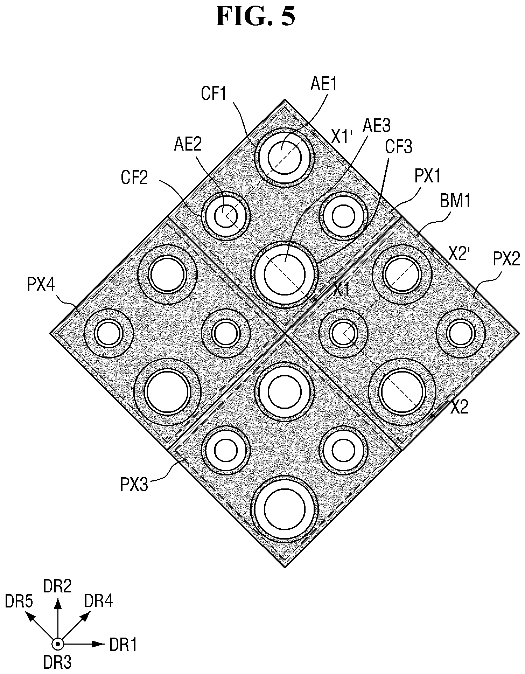

FIG. 4 is a plan view of the display area of the display device according to an embodiment of the present disclosure illustrating the spatial layout of pixel electrodes in the display area of the display device. FIG. 5 is a plan view illustrating the spatial layout of a pixel electrode, a first light blocking layer, and color filters in a display area of a display device according to an embodiment of the present disclosure.

Referring to FIGS. 4 and 5, the display device 10 includes a plurality of pixels PX1, PX2, PX3, and PX4 disposed in the display area DA. The plurality of pixels PX1, PX2, PX3, and PX4 may be arranged in a fourth direction DR4 and a fifth direction DR5, which are diagonal directions between the first direction DR1 and the second direction DR2. The first pixel PX1 and the second pixel PX2 may be disposed adjacent to each other in the fifth direction DR5, and the second pixel PX2 and the third pixel PX3 may be disposed adjacent to each other in the fourth direction DR4. The third pixel PX3 and the fourth pixel PX4 may be disposed adjacent to each other in the fifth direction DR5. The plurality of pixels PX1, PX2, PX3, and PX4 may be repeatedly disposed in the arrangement of FIG. 4 over the entire display area DA.

Each of the plurality of pixels PX1, PX2, PX3, and PX4 includes a plurality of pixel electrodes AE1, AE2, and AE3. For example, each of the plurality of pixels PX1, PX2, PX3, and PX4 may include a first pixel electrode AE1, a second pixel electrode AE2, and a third pixel electrode AE3. One pixel PX1, PX2, PX3, PX4 may include one first pixel electrode AE1, two second pixel electrodes AE2, and one third pixel electrode AE3. However, the present disclosure is not necessarily limited thereto. The number of the pixel electrodes AE1, AE2, and AE3 disposed in the pixels PX1, PX2, PX3, and PX4 may be varied.

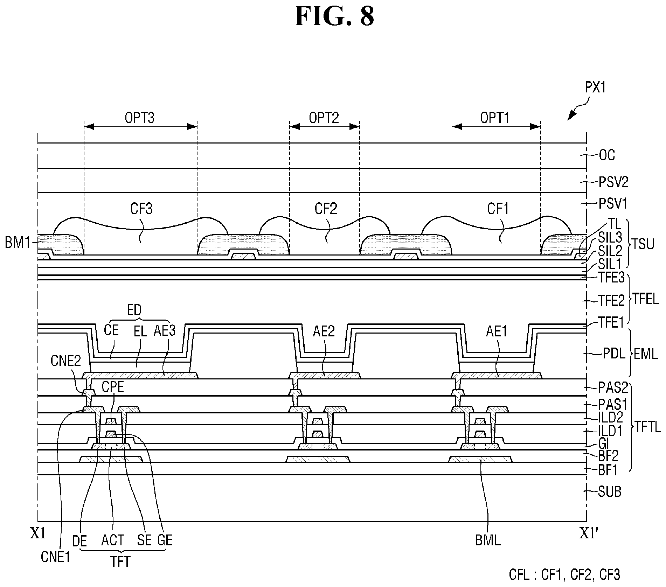

Each of the pixel electrodes AE1, AE2, and AE3 may be an anode electrode of the light emitting element included in each of the pixels PX1, PX2, PX3, and PX4. One pixel PX1, PX2, PX3, PX4 may include one or more light emitting elements ED (see FIG. 8), and the light emitting elements may emit light of different colors. For example, the light emitting element including the first pixel electrode AE1 may emit light of a first color, which is red. The light emitting element including the second pixel electrode AE2 may emit light of a second color, which is green, and the light emitting element including the third pixel electrode AE3 may emit light of a third color, which is blue. However, the present disclosure is not necessarily limited thereto. One first pixel electrode AE1, two second pixel electrodes AE2, and one third pixel electrode AE3 may form one pixel PX1, PX2, PX3, PX4, emit light of different colors, and express a white grayscale. However, the present disclosure is not necessarily limited thereto, and the combination of the pixel electrodes AE1, AE2, and AE3 forming one pixel PX1, PX2, PX3, PX4 may be varied depending on the arrangement of the pixel electrodes AE1, AE2, and AE3, the color of light emitted by them, and the like.

Each of the pixel electrodes AE1, AE2, and AE3 may form an emission area in each of the pixels PX1, PX2, PX3, and PX4. For example, the first pixel electrode AE1 may form a first emission area that emits light of the first color, the second pixel electrode AE2 may form a second emission area that emits light of the second color, and the third pixel electrode AE3 may form a third emission area that emits light of the third color. In some embodiments, the emission areas of the display device 10 may be areas overlapping the pixel electrodes AE1, AE2, and AE3, and for example, openings of a pixel defining layer PDL shown in FIG. 8 may correspond to the emission areas. For example, the emission areas may be defined by the plurality of openings formed in the pixel defining layer PDL (see FIG. 8) of the light emitting element layer EML to be described below. The first emission area may be defined by a first opening of the pixel defining layer overlapping the first pixel electrode AE1, the second emission area may be defined by a second opening of the pixel defining layer overlapping the second pixel electrode AE2, and the third emission area may be defined by a third opening of the pixel defining layer overlapping the third pixel electrode AE3.

The plurality of pixel electrodes AE1, AE2, and AE3 may be disposed in a PENTILE^{™} type, where PENTILE is an arrangement of luminous areas manufactured by SAMSUNG, e.g., a diamond PENTILE^{™} type. For example, the first pixel electrode AE1 and the third pixel electrode AE3 may be spaced apart from each other in the second direction DR2, and they may be alternately disposed in the first direction DR1 and the second direction DR2. The second pixel electrode AE2 may be spaced apart from another adjacent second pixel electrode AE2 in the first direction DR1 and the second direction DR2, and may be spaced apart from the adjacent first pixel electrode AE1 and the adjacent third pixel electrode AE3 in the fourth direction DR4 or the fifth direction DR5. The plurality of second pixel electrodes AE2 may be repeatedly disposed along the first direction DR1 and the second direction DR2, and the second pixel electrode AE2 and the first pixel electrode AE1, or the second pixel electrode AE2 and the third pixel electrode AE3 may be alternately disposed along the fourth direction DR4 or the fifth direction DR5.

In some embodiments, the areas or sizes of the first to third pixel electrodes AE1, AE2, and AE3 may be different from each other. In the embodiment of FIG. 4, the area of the third pixel electrode AE3 may be larger than those of the first pixel electrode AE1 and the second pixel electrode AE2, and the area of the first pixel electrode AE1 may be larger than that of the second pixel electrode AE2. The intensity of emitted light may vary depending on the sizes of the emission areas overlapping the pixel electrodes AE1, AE2, and AE3, and the color displayed on the screen of the display device 10 or the electronic device 1 may be controlled by adjusting the size of the emission area. In the embodiment of FIG. 4, the third pixel electrode AE3 has the largest area, but is not necessarily limited thereto. The sizes of the pixel electrodes AE1, AE2, and AE3 and the sizes of the emission areas may be freely adjusted depending on the color of the screen required in the display device 10 or the electronic device 1. In addition, the areas of the pixel electrodes AE1, AE2, and AE3 may be related to light efficiency and the lifespan of the light emitting element ED, and may have a trade-off relation with the reflection by external light. The areas of the pixel electrodes AE1, AE2, and AE3 may be adjusted in consideration of the above factors.

The display device 10 includes a first light blocking layer BM1 and a plurality of color filters CF1, CF2, and CF3 disposed on the pixel electrodes AE1, AE2, and AE3.

The first light blocking layer BM1 may be disposed over the entire display area DA. The first light blocking layer BM1 includes a plurality of holes OPT1, OPT2, and OPT3 corresponding to the plurality of pixel electrodes AE1, AE2, and AE3, respectively. Alternatively, the holes OPT1, OPT2, and OPT3 of the first light blocking layer BM1 may be corresponding to the openings in the pixel defining layer PDL (see FIG. 8), respectively. The first light blocking layer BM1 may cover the display area DA except for a region where the holes OPT1, OPT2, and OPT3 are disposed in the display area DA. The holes OPT1, OPT2, and OPT3 of the first light blocking layer BM1 may be regions through which light emitted from the light emitting elements including the pixel electrodes AE1, AE2, and AE3 is emitted. The plurality of holes OPT1, OPT2, and OPT3 may include a first hole OPT1 overlapping the first pixel electrode AE1, a second hole OPT2 overlapping the second pixel electrode AE2, and a third hole OPT3 overlapping the third pixel electrode AE3. Within the region occupied by one pixel PX, one first hole OPT1, two second holes OPT2, and one third hole OPT3 may be formed in the first light blocking layer BM1.

The areas of the plurality of holes OPT1, OPT2, and OPT3 in a plan view may be larger than the areas of the pixel electrodes AE1, AE2, and AE3 in a plan view, respectively. For example, the area of the first hole OPT1 may be larger than the area of the first pixel electrode AE1 in a plan view. The areas of the second hole OPT2 and the third hole OPT3 may also be larger than the areas of the second pixel electrode AE2 and the third pixel electrode AE3, respectively, in a plan view. In addition, the holes OPT1, OPT2, and OPT3 of the first light blocking layer BM1 may have different areas in a plan view. As described above, the areas of the plurality of pixel electrodes AE1, AE2, and AE3 may be different from each other, and accordingly, the sizes of the holes OPT1, OPT2, and OPT3 of the first light blocking layer BM1 may also be different from each other. For example, the diameter or size of the third hole OPT3 may be larger than those of the first hole OPT1 and the second hole OPT2, and the diameter or size of the first hole OPT1 may be larger than that of the second hole OPT2. However, the present disclosure is not necessarily limited thereto.

In an embodiment of the present disclosure, the differences in diameters between the pixel electrodes AE1, AE2, and AE3 and the holes OPT1, OPT2, and OPT3 of the first light blocking layer BM1 in the pixels PX1 and PX2 of the same type, or the separation distances between the outer sides of the pixel electrodes AE1, AE2, and AE3 and the inner sides of the holes OPT1, OPT2, and OPT3 may be uniform regardless of the type of the pixel electrodes AE1, AE2, and AE3 or the holes OPT1, OPT2, and OPT3. For example, the separation distance between the first pixel electrode AE1 and the first hole OPT1, or the difference in diameter between the first pixel electrode AE1 and the first hole OPT1 may be the same as the separation distance between the second pixel electrode AE2 and the second hole OPT2, or the difference in diameter between the second pixel electrode AE2 and the second hole OPT2. This may also be the same as the separation distance between the third pixel electrode AE3 and the third hole OPT3, or the difference in diameter between the third pixel electrode AE3 and the third hole OPT3. However, the present disclosure is not necessarily limited thereto, and the separation distances between the pixel electrodes AE1, AE2, and AE3 and the holes OPT1, OPT2, and OPT3 of the first light blocking layer BM1 may be different depending on the type of the pixel electrodes AE1, AE2, and AE3.

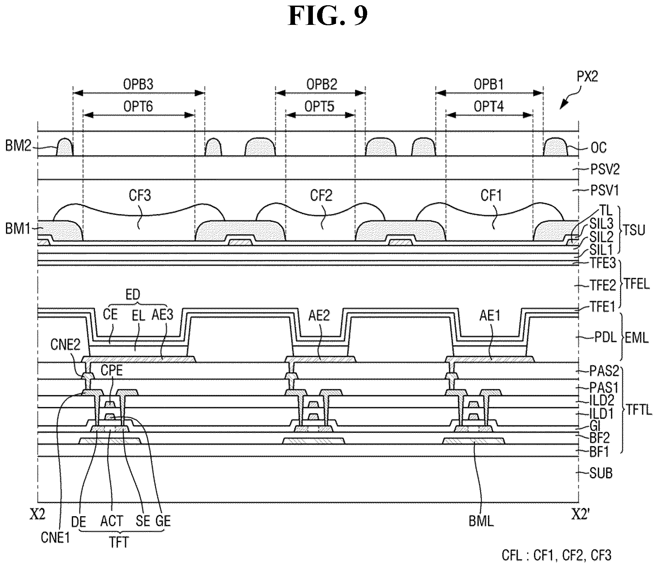

According to an embodiment of the present disclosure, the display device 10 may include the pixels PX1, PX2, PX3, and PX4 having different separation distances between the pixel electrodes AE1, AE2, and AE3 and the holes OPT1, OPT2, OPT3, OPT4, OPT5, and OPT6 of the first light blocking layer BM1. For example, the first pixel PX1 and the third pixel PX3 may have the same separation distance between the pixel electrodes AE1, AE2, and AE3 and the holes OPT1, OPT2, and OPT3 of the first light blocking layer BM1. The second pixel PX2 and the fourth pixel PX4 may also have the same separation distance between the pixel electrodes AE1, AE2, and AE3 and holes OPT4, OPT5, and OPT6 (see FIG. 9) of the first light blocking layer BM1. However, in the first pixel PX1 and the second pixel PX2, the separation distances between the pixel electrodes AE1, AE2, and AE3 and the holes OPT1 to OPT3 and OPT4 to OPT6 of the first light blocking layer BM1 may be different from each other. In an embodiment of the present disclosure, the separation distance between the pixel electrodes AE1, AE2, and AE3 and the holes OPT1, OPT2, and OPT3 of the first light blocking layer BM1 in the first pixel PX1 and the third pixel PX3 may be larger than the separation distance between the pixel electrodes AE1, AE2, and AE3 and the holes OPT4, OPT5, and OPT6 of the first light blocking layer BM1 in the second pixel PX2 and the fourth pixel PX4. In the second pixel PX2 and the fourth pixel PX4, the difference in diameter between the pixel electrodes AE1, AE2, and AE3 and the holes OPT4, OPT5, and OPT6 of the first light blocking layer BM1 may be small, and the outer sides of the pixel electrodes AE1, AE2, and AE3 and the inner sides of the holes OPT1, OPT2, and OPT3 may be located adjacent to each other in a plan view.

The display device 10 may include a first type pixel, such as the first pixel PX1 and the third pixel PX3, and a second type pixel, such as the second pixel PX2 and the fourth pixel PX4. The distinction between the first type pixel and the second type pixel may be made not only by the separation distance between the pixel electrodes AE1, AE2, and AE3 and the holes OPT1, OPT2, and OPT3 of the first light blocking layer BM1, but also by the presence/absence of the second light blocking layer BM2 to be described below. For example, the second light blocking layer BM2 might not be disposed in the first pixel PX1 and the third pixel PX3, and the second light blocking layer BM2 may be disposed in the second pixel PX2 and the fourth pixel PX4. The second light blocking layer BM2 will be described below with reference to other drawings.

The plurality of color filters CF1, CF2, and CF3 is disposed on the first light blocking layer BM1 and corresponds to the plurality of holes OPT1, OPT2, and OPT3 of the first light blocking layer BM1. In other words, the color filters CF1, CF2, and CF3 are disposed on the first light blocking layer BM1 and overlap (fill) the corresponding holes OPT1, OPT2, and OPT3 of the first light blocking layer BM1. Therefore, the plurality of color filters CF1, CF2, and CF3 may correspond to the pixel electrodes AE1, AE2, and AE3, respectively. The holes OPT1, OPT2, and OPT3 of the first light blocking layer BM1 may overlap the openings of the pixel defining layer PDL (see FIG. 8), and may form a light exit area through which light emitted from the emission area is emitted. Each of the color filters CF1, CF2, and CF3 may have areas larger than those of the holes OPT1, OPT2, and OPT3 of the first light blocking layer BM1, respectively, and the color filters CF1, CF2, and CF3 may completely cover the light exit area formed by the holes OPT1, OPT2, and OPT3, respectively. The color filters CF1, CF2, and CF3 (completely) cover the holes OPT1, OPT2, and OPT3 of the first light blocking layer BM1, respectively, and a portion thereof may be disposed (directly) on the first light blocking layer BM1. However, in some embodiments, the color filters CF1, CF2, and CF3 may be omitted.

The color filters CF1, CF2, and CF3 may include a first color filter CF1, a second color filter CF2, and a third color filter CF3 corresponding to the different pixel electrodes AE1, AE2, and AE3, respectively. The color filters CF1, CF2, and CF3 may include a colorant such as a dye or a pigment that absorbs light in a wavelength band other than a specific wavelength band, and may correspond to the color of light emitted by the light emitting element including the pixel electrodes AE1, AE2, and AE3. For example, the first color filter CF1 may be a red color filter that overlaps the first pixel electrode AE1 and transmits only the first light of the red color. The second color filter CF2 may be a green color filter that overlaps the second pixel electrode AE2 and transmits only the second light of the green color, and the third color filter CF3 may be a blue color filter that overlaps the third pixel electrode AE3 and transmits only the third light of the blue color.

Similarly to the spatial layout of the pixel electrodes AE1, AE2, and AE3, the color filters CF1, CF2, and CF3 may be disposed in a PENTILE^{™} type, e.g., a diamond PENTILE^{™} type. For example, the first color filter CF1 and the third color filter CF3 may be alternately disposed in the first direction DR1 and the second direction DR2. The second color filter CF2 and another adjacent second color filter CF2 may be arranged in the first direction DR1 and the second direction DR2, and the second color filter CF2 and the adjacent first color filter CF1 and the adjacent third color filter CF3 may be arranged in the fourth direction DR4 or the fifth direction DR5. The plurality of second color filters CF2 may be repeatedly disposed along the first direction DR1 and the second direction DR2, and the second color filter CF2 and the first color filter CF1, or the second color filter CF2 and the third color filter CF3 may be alternately disposed along the fourth direction DR4 or the fifth direction DR5.

According to an embodiment of the present disclosure, the plurality of color filters CF1, CF2, and CF3 may have different areas in a plan view. As described above, the areas of the plurality of pixel electrodes AE1, AE2, and AE3 may be different from each other, and accordingly, the sizes of the holes OPT1, OPT2, and OPT3 of the first light blocking layer BM1 and the areas of the color filters CF1, CF2, and CF3 in a plan view may also be different from each other. For example, the area of the first color filter CF1, which is a red color filter, may be larger than the area of the second color filter CF2, which is a green color filter, and the area of the third color filter CF3, which is a blue color filter. Additionally, the area of the third color filter CF3 may be larger than the area of the second color filter CF2. The color filters CF1, CF2, and CF3 may have a circular shape in a plan view, similarly to the shape of the pixel electrodes AE1, AE2, and AE3. However, the present disclosure is not necessarily limited thereto, and the color filters CF1, CF2, and CF3 may have a rectangular or rhombic shape in a plan view. The display device 10 according to an embodiment of the present disclosure may be designed such that the planar shape and area of the color filters CF1, CF2, and CF3 allow external light of the display device 10 to have a specific color.

The display device 10 may include the color filters CF1, CF2, and CF3 disposed on the display layer DU to reduce the intensity of reflected light caused by the external light. Furthermore, the color of the reflected light by the external light may be controlled by adjusting the spatial layout (spatial positioning), shape, and area of the color filters CF1, CF2, and CF3 in a plan view. A detailed description thereof will be given below with reference to other drawings.

A touch electrode TL may be disposed between the pixel electrodes AE1, AE2, and AE3. The touch electrode TL may extend in the fourth direction DR4 and the fifth direction DR5 and may be spaced apart from the pixel electrodes AE1, AE2, and AE3. The touch electrode TL may overlap the pixel defining layer PDL (see FIG. 8) and the first light blocking layer BM1. Although the touch electrode TL is simply illustrated in the drawing, the touch electrode TL may include a touch driving electrode and a sensing electrode.

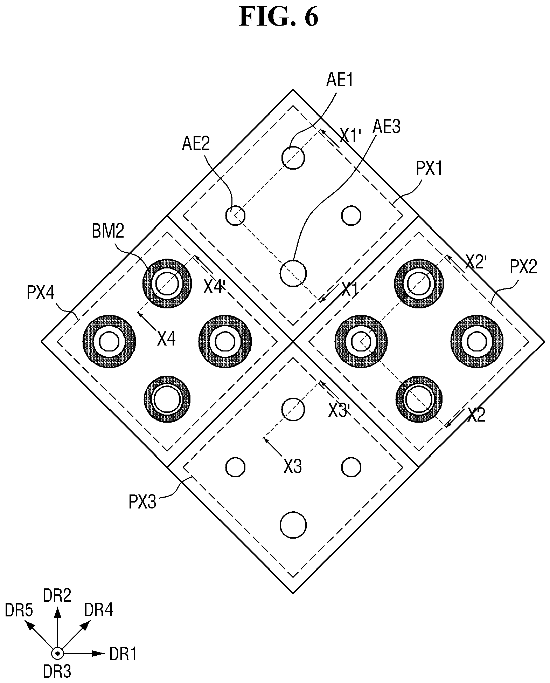

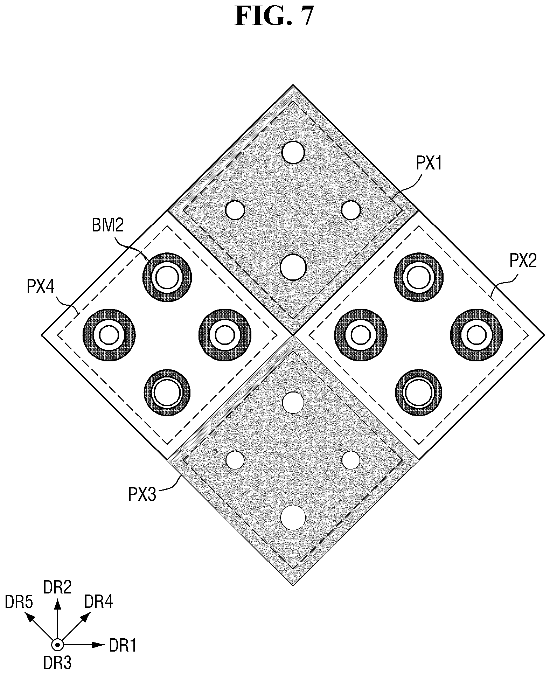

FIG. 6 is a plan view showing the position of a pixel electrode and a second light blocking layer in the display area of the display device according to an embodiment of the present disclosure. FIG. 7 is a schematic diagram illustrating light emitting pixels according to an emission mode of a display device according to an embodiment of the present disclosure. FIG. 7 schematically illustrates the light emitting pixels in an emission mode with partially limited side visibility among the emission modes of the display device 10.

Referring to FIGS. 6 and 7, the display device 10, according to the present disclosure, includes a second light blocking layer BM2. The second light blocking layer BM2 may be disposed only in some of the plurality of pixels in the display area DA. For example, the second light blocking layer BM2 may be disposed in the second type pixel, e.g., the second pixel PX2 and the fourth pixel PX4, of the plurality of pixels PX. As described above, the plurality of pixels PX may include two types of pixels with different separation distances between the pixel electrodes AE1, AE2, and AE3 and the holes OPT1, OPT2, and OPT3 of the first light blocking layer BM1, and the second light blocking layer BM2 may be disposed only in the second type pixel.

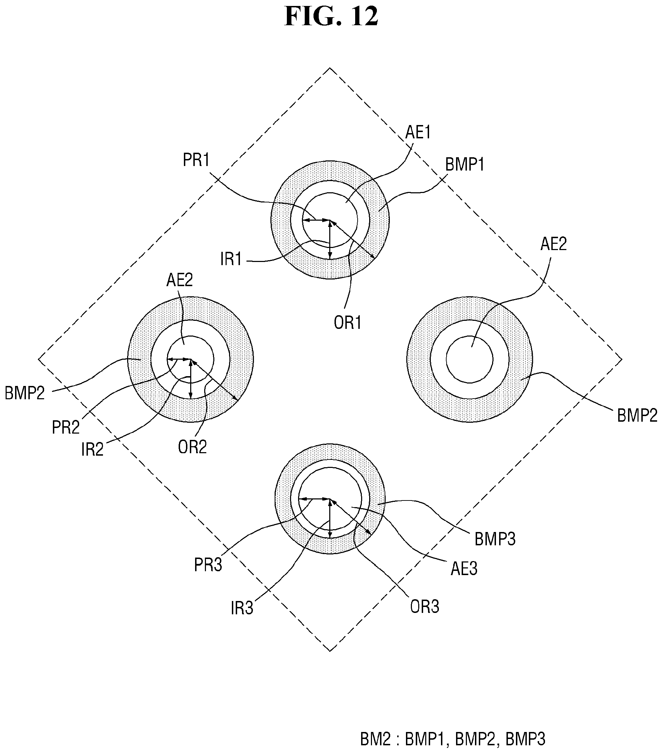

The second light blocking layer BM2 includes a plurality of light blocking patterns BMP1, BMP2, and BMP3 (see FIG. 12), and the light blocking patterns BMP1, BMP2, and BMP3 may correspond to the plurality of pixel electrodes AE1, AE2, and AE3, respectively. For example, the light blocking patterns may each have a uniform width and may surround the pixel electrodes AE1, AE2, and AE3 without overlapping the pixel electrodes AE1, AE2, and AE3 in a plan view. The light blocking patterns may have a circular ring shape that surrounds the pixel electrodes AE1, AE2, and AE3 without covering them in a plan view. Similarly to the holes OPT1, OPT2, and OPT3 of the first light blocking layer BM1, the inner sides of the light blocking patterns may be spaced apart from the outer sides of the pixel electrodes AE1, AE2, and AE3 in a plan view.

In the display device 10, according to an embodiment of the present disclosure, the plurality of pixels PX may include the first type pixel in which the second light blocking layer BM2 is not disposed and the second type pixel in which the second light blocking layer BM2 is disposed, so that the side visibility may be adjusted depending on the emission mode. Depending on the viewing angle of the display device 10, the light blocking patterns of the second light blocking layer BM2 may partially cover the pixel electrodes AE1, AE2, and AE3, and may block the emission of light at a specific viewing angle.

For example, in a first emission mode of the display device 10, when the side visibility is not restricted, both the first type pixel and the second type pixel may emit light. For example, as shown in FIG. 6, when all of the first to fourth pixels PX1, PX2, PX3, and PX4 emit light in the first emission mode, light emitted from at least the first pixel PX1 and the third pixel PX3 may be visually recognized by the user regardless of which direction the user looks at the display device 10.

In a second emission mode of the display device 10, when it is required to restrict the side visibility, only the second type pixel may emit light. For example, as shown in FIG. 7, when only the second pixel PX2 and the fourth pixel PX4 emit light in the second emission mode, light emitted from the holes OPT1, OPT2, and OPT3 of the first light blocking layer BM1 may be blocked by the second light blocking layer BM2 at a specific viewing angle. Since the first pixel PX1 and the third pixel PX3 do not emit light, the screen of the display device 10 in the second emission mode may be visually recognized only by the user looking from the front of the display area DA, and might not be visually recognized by the user looking from a specific viewing angle such as from the side. The display device 10 may provide a privacy protection mode to the user who is looking from the front.

In the second emission mode of the display device 10, a light leakage phenomenon of light emitted from the pixel electrodes AE1, AE2, and AE3 of the second pixel PX2 and the fourth pixel PX4 may occur depending on the extent to which they are covered by the second light blocking layer BM2. However, in the display device 10, according to an embodiment of the present disclosure, the light blocking patterns of the second light blocking layer BM2 may surround the pixel electrodes AE1, AE2, and AE3 in correspondence with the shape of the pixel electrodes AE1, AE2, and AE3. In the display device 10, the extent to which the pixel electrodes AE1, AE2, and AE3 of the second type pixel are covered may be uniform at all viewing angles looking at the display device 10 in the second emission mode, and it is possible to prevent the light leakage phenomenon of light emitted from the light emitting elements including the specific pixel electrodes AE1, AE2, and AE3.

In addition, in the display device 10, since the light blocking patterns of the second light blocking layer BM2 correspond to the pixel electrodes AE1, AE2, and AE3 of the second type pixel, they might not extend into other adjacent pixels, e.g., the first type pixel, and thus might not cover the pixel electrode of the first type pixel in the first emission mode. For example, in the display device 10, the layout of the pixel structure may be freely designed even in the implementation of a high-resolution display device.

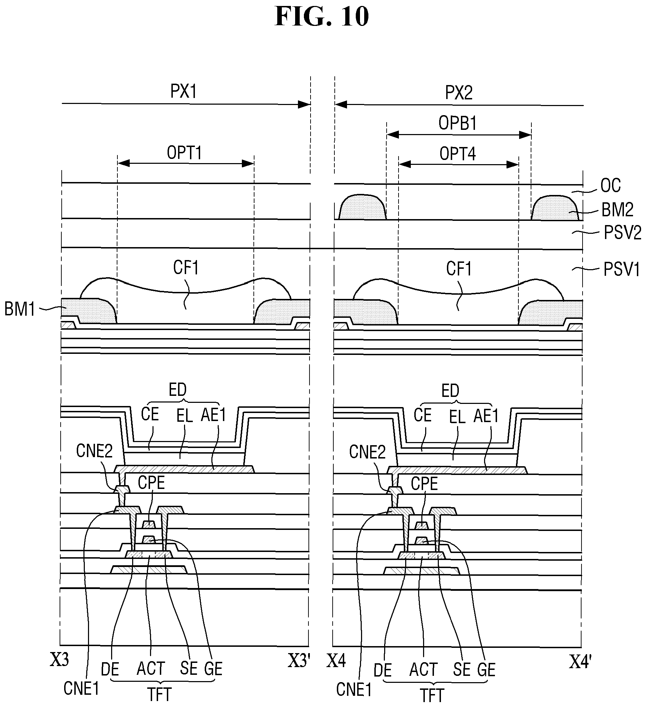

FIG. 8 is a cross-sectional view taken along line X1-X1' of FIGS. 5 and 6. FIG. 9 is a cross-sectional view taken along line X2-X2' of FIGS. 5 and 6. FIG. 10 is a cross-sectional view taken along lines X3-X3' and X4-X4' of FIGS. 5 and 6.

FIG. 8 shows a cross section across the first to third pixel electrodes AE1, AE2, and AE3 in the first pixel PX1 which is the first type pixel. FIG. 9 shows a cross section across the first to third pixel electrodes AE1, AE2, and AE3 in the second pixel PX2 which is the second type pixel. FIG. 10 shows a cross section across the first pixel electrode AE1 of the first type pixel and the first pixel electrode AE1 of the second type pixel.

A cross-sectional structure of the display device 10 will be described with reference to FIGS. 8 to 10. The display panel 100 of the display device 10 may include the display layer DU, the touch sensing layer TSU, the first light blocking layer BM1, the color filter layer CFL, and the second light blocking layer BM2. The display layer DU may include the substrate SUB, the thin film transistor layer TFTL, the light emitting element layer EML, and the encapsulation layer TFEL. The first light blocking layer BM1 may be disposed on the touch sensing layer TSU of the display panel 100, and the color filters CF1, CF2, and CF3 of the color filter layer CFL may be disposed on the first light blocking layer BM1. The second light blocking layer BM2 may be disposed on passivation layers PSV1 and PSV2 disposed on the color filter layer CFL, and an overcoat layer OC may be disposed on the second light blocking layer BM2.

The substrate SUB may be a base substrate or a base member. The substrate SUB may be a flexible substrate which can be bent, folded or rolled. For example, the substrate SUB may include a polymer resin such as polyimide (PI), but is not necessarily limited thereto. For example, the substrate SUB may include a glass or a metal.

The thin film transistor layer TFTL may include a first buffer layer BF1, a lower metal layer BML, a second buffer layer BF2, a thin film transistor TFT, a gate insulating layer GI, a first interlayer insulating layer ILD1, a capacitor electrode CPE, a second interlayer insulating layer ILD2, a first connection electrode CNE1, a first passivation layer PAS1, a second connection electrode CNE2, and a second passivation layer PAS2.

The first buffer layer BF1 may be disposed on the substrate SUB. The first buffer layer BF1 may include an inorganic layer capable of preventing penetration of air or moisture. For example, the first buffer layer BF1 may include a plurality of inorganic layers that are alternately stacked.

The lower metal layer BML may be disposed on the first buffer layer BF1. For example, the lower metal layer BML may be formed as a single layer or multiple layers including molybdenum (Mo), aluminum (Al), chromium (Cr), gold (Au), titanium (Ti), nickel (Ni), neodymium (Nd) and/or copper (Cu) and/or an alloy thereof.

The second buffer layer BF2 may cover the first buffer layer BF1 and the lower metal layer BML. The second buffer layer BF2 may include an inorganic layer capable of preventing penetration of air or moisture. For example, the second buffer layer BF2 may include a plurality of inorganic layers alternately stacked.

The thin film transistor TFT may be disposed on the second buffer layer BF2, and may constitute a pixel circuit of each of a plurality of pixels. For example, the thin film transistor TFT may be a switching transistor or a driving transistor of the pixel circuit. The thin film transistor TFT may include a semiconductor layer ACT, a source electrode SE, a drain electrode DE, and a gate electrode GE.

The semiconductor layer ACT may be disposed on the second buffer layer BF2. The semiconductor layer ACT may overlap the lower metal layer BML and the gate electrode GE in the thickness direction, and may be insulated from the gate electrode GE by the gate insulating layer GI. In a part of the semiconductor layer ACT, a material of the semiconductor layer ACT may be made into a conductor to form the source electrode SE and the drain electrode DE.

The gate electrode GE may be disposed on the gate insulating layer GI. The gate electrode GE may overlap the semiconductor layer ACT with the gate insulating layer GI interposed therebetween.

The gate insulating layer GI may be disposed on the semiconductor layer ACT. For example, the gate insulating layer GI may cover the semiconductor layer ACT and the second buffer layer BF2 to insulate the gate electrode GE from the semiconductor layer ACT. The gate insulating layer GI may include a contact hole through which the first connection electrode CNE1 passes.

The first interlayer insulating layer ILD1 may cover the gate electrode GE and the gate insulating layer GI. The first interlayer insulating layer ILD1 may include a contact hole through which the first connection electrode CNE1 passes. The contact hole of the first interlayer insulating layer ILD1 may be connected to the contact hole of the gate insulating layer GI and the contact hole of the second interlayer insulating layer ILD2.

The capacitor electrode CPE may be disposed on the first interlayer insulating layer ILD1. The capacitor electrode CPE may overlap the gate electrode GE in the thickness direction. The capacitor electrode CPE and the gate electrode GE may form a capacitance.

The second interlayer insulating layer ILD2 may cover the capacitor electrode CPE and the first interlayer insulating layer ILD1. The second interlayer insulating layer ILD2 may include a contact hole through which the first connection electrode CNE1 passes. The contact hole of the second interlayer insulating layer ILD2 may be connected to the contact hole of the first interlayer insulating layer ILD1 and the contact hole of the gate insulating layer GI.

The first connection electrode CNE1 may be disposed on the second interlayer insulating layer ILD2. The first connection electrode CNE1 may electrically connect the drain electrode DE of the thin film transistor TFT to the second connection electrode CNE2. The first connection electrode CNE1 may be inserted into a contact hole provided in the second interlayer insulating layer ILD2, the first interlayer insulating layer ILD1, and the gate insulating layer GI to be in contact with the drain electrode DE of the thin film transistor TFT.

The first passivation layer PAS1 may cover the first connection electrode CNE1 and the second interlayer insulating layer ILD2. The first passivation layer PAS1 may protect the thin film transistor TFT. The first passivation layer PAS1 may include a contact hole through which the second connection electrode CNE2 passes.

The second connection electrode CNE2 may be disposed on the first passivation layer PAS1. The second connection electrode CNE2 may electrically connect the first connection electrode CNE1 to a pixel electrode AE of the light emitting element ED. The second connection electrode CNE2 may be inserted into a contact hole formed in the first passivation layer PAS1 to be in contact with the first connection electrode CNE1.

The second passivation layer PAS2 may cover the second connection electrode CNE2 and the first passivation layer PAS1. The second passivation layer PAS2 may include a contact hole through which the pixel electrode AE of the light emitting element ED passes.

The light emitting element layer EML may be disposed on the thin film transistor layer TFTL. The light emitting element layer EML may include the light emitting element ED and the pixel defining layer PDL. The light emitting element ED may include the pixel electrodes AE1, AE2, and AE3, a light emitting layer EL, and a common electrode CE.

The pixel electrodes AE1, AE2, and AE3 may be disposed on the second passivation layer PAS2. The different pixel electrodes AE1, AE2, and AE3 may each overlap any one of the different openings of the pixel defining layer PDL. The pixel electrodes AE1, AE2, and AE3 may be electrically connected to the drain electrode DE of the thin film transistor TFT through the first and second connection electrodes CNE1 and CNE2.

The light emitting layer EL may be disposed on the pixel electrodes AE1, AE2, and AE3. For example, the light emitting layer EL may be an organic light emitting layer made of an organic material, but is not necessarily limited thereto. In the case of employing the organic light emitting layer as the light emitting layer EL, the thin film transistor TFT applies a predetermined voltage to the pixel electrodes AE1, AE2, and AE3 of the light emitting element ED, and if the common electrode CE of the light emitting element ED receives a common voltage or a cathode voltage, the holes and electrons can move to the light emitting layer EL through the hole transporting layer and the electron transporting layer and combine to produce light to be emitted by the light emitting layer EL.

In some embodiments, the light emitting layers EL disposed on different pixel electrodes AE1, AE2, and AE3 may emit light of different colors. For example, the light emitting layer disposed on the first pixel electrode AE1 may emit red light of the first color, the light emitting layer disposed on the second pixel electrode AE2 may emit green light of the second color, and the light emitting layer disposed on the third pixel electrode AE3 may emit blue light of the third color. However, the present disclosure is not necessarily limited thereto. In an embodiment of the present disclosure, the light emitting layer EL may be disposed as a single common layer on the different pixel electrodes AE1, AE2, and AE3 and the pixel defining layer PDL, and the light emitting layer EL disposed on the different pixel electrodes AE1, AE2, and AE3 may emit light of the same color. In this case, the display device 10 may further include a color adjustment layer disposed on the light emitting elements ED.

The common electrode CE may be disposed on the light emitting layer EL. For example, the common electrode CE may be made in the form of an electrode common to all of the pixels rather than specific to each of the pixels. The common electrode CE may be disposed on the light emitting layer EL in the first to third pixel electrodes AE1, AE2, and AE3, and may be disposed on the pixel defining layer PDL in an area other than the first to third pixel electrodes AE1, AE2, and AE3.

The common electrode CE may receive the common voltage or a low potential voltage. When the pixel electrode AE receives a voltage corresponding to a data voltage and the common electrode CE receives the low potential voltage, a potential difference is formed between the pixel electrodes AE1, AE2, and AE3 and the common electrode CE, so that the light emitting layer EL may emit light.

The pixel defining layer PDL may include a plurality of openings and may be disposed on a part of the pixel electrodes AE1, AE2, and AE3 and the second passivation layer PAS2. Each opening of the pixel defining layer PDL may expose a part of the pixel electrodes AE1, AE2, and AE3. As described above, the respective openings of the pixel defining layer PDL may define the first to third emission areas, and the areas or sizes thereof may be different from each other. The pixel defining layer PDL may separate and insulate the pixel electrodes AE1, AE2, and AE3 of each of the plurality of light emitting elements ED. The pixel defining layer PDL may include a light absorbing material to prevent light reflection. For example, the pixel defining layer PDL may include a polyimide (PI)-based binder and a pigment in which red, green, and blue colors are mixed. Alternatively, the pixel defining layer PDL may include a cardo-based binder resin and a mixture of a lactam black pigment and a blue pigment. Alternatively, the pixel defining layer PDL may include carbon black.

The encapsulation layer TFEL may be disposed on the common electrode CE and may cover the plurality of light emitting elements ED. The encapsulation layer TFEL may include at least one inorganic layer to prevent oxygen or moisture from penetrating into the light emitting element layer EML. The encapsulation layer TFEL may include at least one organic layer to protect the light emitting element layer EML from foreign matter such as dust.

In some embodiments, the encapsulation layer TFEL may include a first encapsulation layer TFE1, a second encapsulation layer TFE2, and a third encapsulation layer TFE3. The first encapsulation layer TFE1 and the third encapsulation layer TFE3 may be inorganic encapsulation layers, and the second encapsulation layer TFE2 disposed between the first encapsulation layer TFE1 and the third encapsulation layer TFE3 may be an organic encapsulation layer.

Each of the first encapsulation layer TFE1 and the third encapsulation layer TFE3 may include one or more inorganic insulating materials. The inorganic insulating material may include aluminum oxide, titanium oxide, tantalum oxide, hafnium oxide, zinc oxide, silicon oxide, silicon nitride, and/or silicon oxynitride.

The second encapsulation layer TFE2 may include a polymer-based material. Examples of the polymer-based material may include acrylic resin, epoxy resin, polyimide, polyethylene and the like. For example, the second encapsulation layer TFE2 may include an acrylic resin, for example, polymethyl methacrylate, polyacrylic acid, or the like. The second encapsulation layer TFE2 may be formed by curing a monomer or applying a polymer.

The touch sensing layer TSU may be disposed on the encapsulation layer TFEL. The touch sensing layer TSU may include a first touch insulating layer SIL1, a second touch insulating layer SIL2, the touch electrode TL, and a third touch insulating layer SIL3.

The first touch insulating layer SIL1 may be disposed on the encapsulation layer TFEL. The first touch insulating layer SIL1 may have an insulating and optical function. The first touch insulating layer SIL1 may include at least one inorganic layer. Optionally, the first touch insulating layer SIL1 may be omitted.

The second touch insulating layer SIL2 may cover the first touch insulating layer SIL1. In some embodiments, a touch electrode of another layer may be further disposed on the first touch insulating layer SIL1, and in this case, the second touch insulating layer SIL2 may cover the touch electrode disposed on the first touch insulating layer SIL1. The second touch insulating layer SIL2 may have an insulating and optical function. For example, the second touch insulating layer SIL2 may be an inorganic layer containing at least one of a silicon nitride layer, a silicon oxynitride layer, a silicon oxide layer, a titanium oxide layer, or an aluminum oxide layer.

A part of the touch electrode TL may be disposed on the second touch insulating layer SIL2. The touch electrode TL might not overlap the first to third pixel electrodes AE1, AE2, and AE3. The touch electrode TL may be formed of a single layer containing molybdenum (Mo), titanium (Ti), copper (Cu), aluminum (Al), or indium tin oxide (ITO), or may have a stacked structure (Ti/Al/Ti) of aluminum and titanium, a stacked structure (ITO/Al/ITO) of aluminum and ITO, an Ag-Pd-Cu (APC) alloy, or a stacked structure (ITO/APC/ITO) of APC alloy and ITO.

The touch electrode TL of the touch sensing layer TSU may have a constant line width and may overlap the first light blocking layer BM1, which will be described below. The first light blocking layer BM1 may have a width sufficient to completely cover the touch electrode TL, and a gap between the edge of the first light blocking layer BM1 and the touch electrode TL may be defined. In some embodiments, the line width of the touch electrode TL may be in a range of 4 µm to 6 µm, and the gap between the touch electrode TL and the edge of the first light blocking layer BM1 may be in a range of 5 µm to 7 µm. The touch electrode TL may be disposed such that its center is substantially aligned with the center of the first light blocking layer BM1, and the gap from both sides of the touch electrode TL to the edge of the first light blocking layer BM1 may be substantially constant.

The third touch insulating layer SIL3 may cover the touch electrode TL and the second touch insulating layer SIL2. The third touch insulating layer SIL3 may have an insulating and optical function. The third touch insulating layer SIL3 may be made of the material exemplified in association with the second touch insulating layer SIL2.

The first light blocking layer BM1 may be disposed on the third touch insulating layer SIL3 of the touch sensing layer TSU. The first light blocking layer BM1 may cover the conductive line of the touch electrode TL, while including the plurality of holes OPT1, OPT2, OPT3, OPT4, OPT5, and OPT6 that overlap the pixel electrodes AE1, AE2, and AE3. For example, the first hole OPT1 may overlap the first pixel electrode AE1 of the first pixel PX1. The second hole OPT2 may overlap the second pixel electrode AE2 of the first pixel PX1, and the third hole OPT3 may overlap the third pixel electrode AE3 of the first pixel PX1. A fourth hole OPT4 may overlap the first pixel electrode AE1 of the second pixel PX2. A fifth hole OPT5 may overlap the second pixel electrode AE2 of the second pixel PX2, and a sixth hole OPT6 may overlap the third pixel electrode AE3 of the second pixel PX2. The area or size of each of the holes OPT1, OPT2, OPT3, OPT4, OPT5, and OPT6 may be larger than the area or size of the corresponding pixel electrode AE1, AE2, AE3. In addition, the area or size of each of the holes OPT1, OPT2, and OPT3 may be larger than that of the corresponding opening of the pixel defining layer PDL, and light emitted from the light emitting element ED may be visually recognized by the user not only from the front of the display device 10 but also from the side thereof. However, whether the first pixel PX1 and the second pixel PX2 emit light or not may depend on the emission mode of the display device 10, and the shape of the first light blocking layer BM1 may be designed such that light of the second pixel PX2 is not visually recognized at a specific viewing angle in an emission mode with restricted side visibility.

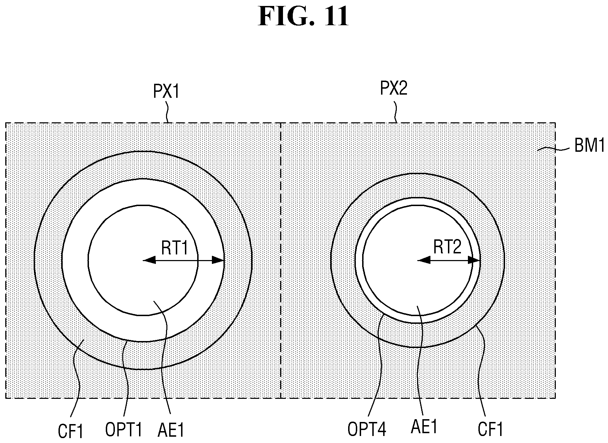

FIG. 11 is a diagram illustrating the relative position of a pixel electrode and a first light blocking layer disposed in one pixel of a display device according to an embodiment of the present disclosure.

Referring to FIG. 11, in the display device 10, according to an embodiment of the present disclosure, the sizes of the first to third holes OPT1, OPT2, and OPT3 disposed in the first pixel PX1 may be larger than the sizes of the fourth to sixth holes OPT4, OPT5, and OPT6 disposed in the second pixel PX2. For example, the size or a radius RT1 of the first hole OPT1 overlapping the first pixel electrode AE1 in the first pixel PX1 may be larger than the size or a radius RT2 of the fourth hole OPT4 overlapping the first pixel electrode AE1 in the second pixel PX2.

In the second emission mode of the display device 10, only the second type pixel may emit light, while the first type pixel might not emit light. When the second type pixel emits light, the sizes of the holes OPT4, OPT5, and OPT6 of the first light blocking layer BM1 in the second pixel PX2 may be relatively small so as to block light emission at a specific viewing angle. In addition, since the second light blocking layer BM2 is disposed in the second type pixel, the second emission mode of the display device 10 may control the side visibility of light emitted from the second type pixel.

In the first emission mode, both the first pixel PX1 and the second pixel PX2 may emit light and may be visually recognized from both the front and the side. Accordingly, in the first pixel PX1, the diameters of the pixel electrodes AE1, AE2, and AE3 and the first to third holes OPT1, OPT2, and OPT3 may be equal to or greater than a certain level in order to secure visibility from the side. In the second emission mode, only the second pixel PX2 may emit light, while the first pixel PX1 might not emit light, and side visibility may be restricted. In the second emission mode, light of the second pixel PX2 might not be visually recognized at a side viewing angle except for a viewing angle close to the front. The diameter of the fourth to sixth holes OPT4, OPT5, and OPT6 disposed in the second pixel PX2 may be little different from the diameter of the pixel electrodes AE1, AE2, and AE3, and visibility may be restricted even at a small side viewing angle. In addition, the second light blocking layer BM2, which will be described below, may be provided in the second pixel PX2 to further restrict side visibility.

In the display device 10, the pixel electrodes AE1, AE2, and AE3 of the same type disposed in each of the first pixel PX1 and the second pixel PX2, e.g., a diameter of the first pixel electrode AE1 of the first pixel PX1 may be equal to a diameter of the first pixel electrode AE1 of the second pixel PX2, and the first hole OPT1 disposed in the first pixel PX1 may have a larger diameter than that of the fourth hole OPT4 disposed in the second pixel PX2. In some embodiments, the difference in diameter between the holes OPT4, OPT5, and OPT6 and the pixel electrodes AE1, AE2, and AE3 in the second pixel PX2 may be adjusted based on the patterning process capability of the first light blocking layer BM1, and the difference in diameter between the holes OPT1, OPT2, and OPT3 and the pixel electrodes AE1, AE2, and AE3 in the first pixel PX1 may be adjusted based on the optical distance from the pixel electrodes AE1, AE2, and AE3 in addition to the above patterning process capability. In an embodiment of the present disclosure, the difference in diameter between the holes OPT4, OPT5, and OPT6 and the pixel electrodes AE1, AE2, and AE3 in the second pixel PX2 may be 1.0 µm to 1.5 µm, or about 1.2 µm, and the difference in diameter between the holes OPT1, OPT2, and OPT3 of the first pixel PX1 and the pixel electrodes AE1, AE2, and AE3 may be 4.5 µm to 6.5 µm, or about 5 µm. The difference in diameter between the holes OPT1, OPT2, and OPT3 of the first pixel PX1 and the holes OPT4, OPT5, and OPT6 of the second pixel PX2 may be a value designed in consideration of the above-described optical distance, e.g., the distance between the pixel electrodes AE1, AE2, and AE3 and the top surface of the second encapsulation layer TFE2. However, the present disclosure is not necessarily limited thereto, and the difference in diameter between the holes disposed in the first pixel PX1 and the second pixel PX2 may be designed and modified in various ways according to the optical characteristic conditions required or demanded for the electronic device 1.

The first light blocking layer BM1 may include a light absorbing material. For example, the first light blocking layer BM1 may include an inorganic black pigment or an organic black pigment. The inorganic black pigment may be carbon black, and the organic black pigment may include at least one of lactam black, perylene black, or aniline black, but they are not necessarily limited thereto. The first light blocking layer BM1 may prevent visible light infiltration and color mixture between the holes OPT1, OPT2, and OPT3, which leads to the improvement of color reproducibility of the display device 10. In some embodiments, the first light blocking layer BM1 may have a thickness of 1 µm to 3 µm, or about 1.5 µm.

The color filters CF1, CF2, and CF3 of the color filter layer CFL may be disposed on the first light blocking layer BM1. The different color filters CF1, CF2, and CF3 may correspond to the different pixel electrodes AE1, AE2, and AE3 and the holes OPT1, OPT2, and OPT3 of the first light blocking layer BM1, respectively. For example, the first color filter CF1 may correspond to the first pixel electrode AE1, the second color filter CF2 may correspond to the second pixel electrode AE2, and the third color filter CF3 may correspond to the third pixel electrode AE3. The first color filter CF1 may be disposed in the first hole OPT1 of the first light blocking layer BM1, the second color filter CF2 may be disposed in the second hole OPT2 of the first light blocking layer BM1, and the third color filter CF3 may be disposed in the third hole OPT3 of the first light blocking layer BM1. Each of the color filters CF1, CF2, and CF3 may have a larger area in a plan view than the holes OPT1, OPT2, and OPT3 of the first light blocking layer BM1, and some may be disposed directly on the first light blocking layer BM1.

The areas of the plurality of color filters CF1, CF2, and CF3 may vary depending on the sizes of the holes OPT1, OPT2, OPT3, OPT4, OPT5, and OPT6 of the first light blocking layer BM1. For example, the area of the first color filter CF1 may be larger than that of the second color filter CF2, but smaller than that of the third color filter CF3 in a plan view. In some embodiments, the area of the first color filter CF1 disposed in the first pixel PX1 in a plan view may be the same as the area of the first color filter CF1 disposed in the second pixel PX2 in a plan view. However, the present disclosure is not necessarily limited thereto. In some embodiments, the area of the first color filter CF1 disposed in the first pixel PX1 in a plan view may be larger than the area of the first color filter CF1 disposed in the second pixel PX2 in a plan view.

The passivation layers PSV1 and PSV2 may be disposed on the first light blocking layer BM1 and the color filter layer CFL. The passivation layers PSV1 and PSV2 may be disposed over the entire display area DA to planarize the top surface of the display panel 100. The passivation layers PSV1 and PSV2 may include a first passivation layer PSV1 disposed on the color filter layer CFL and the first light blocking layer BM1, and a second passivation layer PSV2 disposed on the first passivation layer PSV1. The passivation layers PSV1 and PSV2 may be formed of a plurality of layers to planarize a stepped portion caused by the color filter layer CFL and the first light blocking layer BM1.

The passivation layers PSV1 and PSV2 may be a colorless light transmissive layer that does not have a color in a visible light band. For example, the passivation layers PSV1 and PSV2 may include a colorless light transmissive organic material such as an acrylic resin.

The second light blocking layer BM2 may be disposed on the passivation layers PSV1 and PSV2. The second light blocking layer BM2 might not be disposed in the first type pixel (or the first pixel PX1), but may be disposed only in the second type pixel (or the second pixel PX2). The second light blocking layer BM2 may correspond to the periphery of the pixel electrodes AE1, AE2, and AE3 of the second type pixel, and may form transmission portions OPB1, OPB2, and OPB3 that overlap the pixel electrodes AE1, AE2, and AE3. For example, the second light blocking layer BM2 may include a first transmission portion OPB1 overlapping the first pixel electrode AE1, a second transmission portion OPB2 overlapping the second pixel electrode AE2, and a third transmission portion OPB3 overlapping the third pixel electrode AE3. The transmission portions OPB1, OPB2, and OPB3 may also overlap the holes OPT4, OPT5, and OPT6 of the first light blocking layer BM1, respectively.

In an embodiment of the present disclosure, the diameter or area of the transmission portions OPB1, OPB2, and OPB3 of the second light blocking layer BM2 in a plan view may be larger than the diameter or area of the holes OPT4, OPT5, and OPT6 of the first light blocking layer BM1 and the pixel electrodes AE1, AE2, and AE3 in a plan view. Light emitted from the light emitting elements ED including the pixel electrodes AE1, AE2, and AE3 may be emitted through the holes OPT4, OPT5, and OPT6 of the first light blocking layer BM1 and the transmission portions OPB1, OPB2, and OPB3 of the second light blocking layer BM2. The light emitted from the second type pixel is finally emitted after passing through the transmission portions OPB1, OPB2, and OPB3, and a lot of light may be visually recognized at least when the display device 10 is viewed from the front.

However, when the display device 10 is viewed from the side, the light emitted from the second type pixel may be blocked by the second light blocking layer BM2 even if the light passes through the holes OPT4, OPT5, and OPT6 of the first light blocking layer BM1. For example, the display device 10 may allow only the second pixel PX2 or the second type pixel in which the second light blocking layer BM2 is disposed to emit light in the second emission mode, thereby controlling visibility at a specific viewing angle and providing a privacy protection mode to the user.

The second light blocking layer BM2 may include a light absorbing material. For example, the second light blocking layer BM2 may include an inorganic black pigment or an organic black pigment. The inorganic black pigment may be carbon black, and the organic black pigment may include at least one of lactam black, perylene black, or aniline black, but they are not necessarily limited thereto. In some embodiments, the second light blocking layer BM2 may have a thickness of 1 µm to 3 µm, or about 1.5 µm.

The overcoat layer OC may be disposed on the second light blocking layer BM2 and the passivation layers PSV1 and PSV2. The overcoat layer OC may be disposed over the entire the display area DA to planarize the top surface of the display panel 100. The overcoat layer OC may be a colorless light transmissive layer that does not have a color in a visible light band. For example, the overcoat layer OC may include a colorless light transmissive organic material such as an acrylic resin.

Hereinafter, the second light blocking layer BM2 and the pixel electrodes AE1, AE2, and AE3 of the display device 10 will be described in more detail below with reference to other drawings.

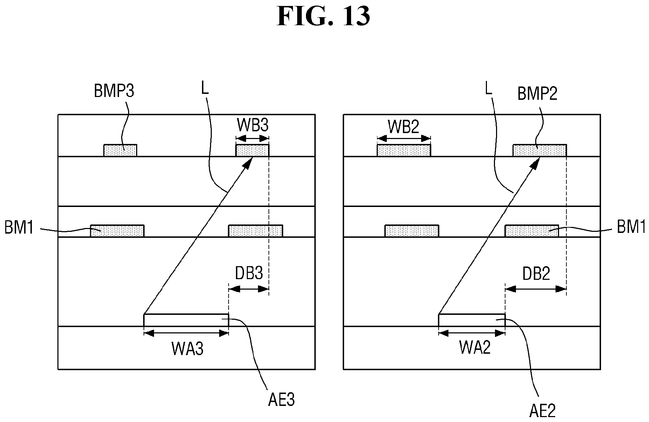

FIG. 12 is a diagram illustrating the relative position of a pixel electrode and a second light blocking layer disposed in a second type pixel of a display device according to an embodiment of the present disclosure. FIG. 13 is an example diagram illustrating a relative position of a second light blocking layer and an emission direction of light emitted from a pixel electrode of a display device. FIG. 12 illustrates an example of the second pixel PX2 or the second type pixel in which the second light blocking layer BM2 is disposed. FIG. 13 illustrates the size variation of the light blocking patterns BMP2 and BMP3 according to the pixel electrodes AE2 and AE3 having different diameters.

Referring to FIGS. 12 and 13, in the display device 10, diameters PR1, PR2, and PR3 of the different pixel electrodes AE1, AE2, and AE3 may be different from each other. For example, the diameter PR3 of the third pixel electrode AE3 may be larger than the diameters PR1 and PR2 of the first pixel electrode AE1 and the second pixel electrode AE2. The diameter PR1 of the first pixel electrode AE1 may be larger than the diameter PR2 of the second pixel electrode AE2. This may mean that the areas of the pixel electrodes AE1, AE2, and AE3 are designed in consideration of the wavelength of light emitted from the light emitting element ED including each of the pixel electrodes AE1, AE2, and AE3, the lifespan of the light emitting element ED, and the like.

As described above, in the display device 10, the pixel electrodes AE1, AE2, and AE3 of the same type disposed in each of the first pixel PX1 and the second pixel PX2 may have the same diameter. For example, the first pixel electrode AE1 disposed in the first pixel PX1 may have the same diameter as the first pixel electrode AE1 disposed in the second pixel PX2.

In the second pixel PX2, the second light blocking layer BM2 may include the light blocking patterns BMP1, BMP2, and BMP3 that correspond to the pixel electrodes AE1, AE2, and AE3 and surround the pixel electrodes AE1, AE2, and AE3 in a plan view, respectively. For example, the second light blocking layer BM2 may include a first light blocking pattern BMP1 surrounding the first pixel electrode AE1, a second light blocking pattern BMP2 surrounding the second pixel electrode AE2, and a third light blocking pattern BMP3 surrounding the third pixel electrode AE3. In the same manner as the number and spatial layout of the pixel electrodes AE1, AE2, and AE3 included in one pixel PX, one second pixel PX2 may include one first light blocking pattern BMP1, two second light blocking patterns BMP2, and one third light blocking pattern BMP3, and they may be spaced apart from each other in a diagonal direction. However, the present disclosure is not necessarily limited thereto.

The plurality of light blocking patterns BMP1, BMP2, and BMP3 of the second light blocking layer BM2 may form the transmission portions OPB1, OPB2, and OPB3 (see FIG. 9) overlapping the pixel electrodes AE1, AE2, and AE3, and may have a circular ring shape with inner radii IR1, IR2, and IR3 and outer diameters OR1, OR2, and OR3 measured from the center of the pixel electrodes AE1, AE2, and AE3 and the widths of the light blocking patterns BMP1, BMP2, and BMP3 themselves.

According to an embodiment of the present disclosure, the plurality of light blocking patterns BMP1, BMP2, and BMP3 of the second light blocking layer BM2 may have the same inner radii IR1, IR2, and IR3, and the differences between the inner radii IR1, IR2, and IR3 and the radii PR1, PR2, and PR3 of the pixel electrodes AE1, AE2, and AE3 or the separation distances between the light blocking patterns BMP1, BMP2, and BMP3 and the pixel electrodes AE1, AE2, and AE3 may be different from each other. For example, the inner radius IR1 of the first light blocking pattern BMP1, the inner radius IR2 of the second light blocking pattern BMP2, and the inner radius IR3 of the third light blocking pattern BMP3 may be the same. The difference between the inner radius IR3 of the third light blocking pattern BMP3 and the radius PR3 of the third pixel electrode AE3 may be smaller than the difference between the inner radius IR1 of the first light blocking pattern BMP1 and the radius PR1 of the first pixel electrode AE1, and the difference between the inner radius IR2 of the second light blocking pattern BMP2 and the radius PR2 of the second pixel electrode AE2. The difference between the inner radius IR1 of the first light blocking pattern BMP1 and the radius PR1 of the first pixel electrode AE1 may be smaller than the difference between the inner radius IR2 of the second light blocking pattern BMP2 and the radius PR2 of the second pixel electrode AE2. The separation distances between the pixel electrodes AE1, AE2, and AE3 and the light blocking patterns BMP1, BMP2, and BMP3 may be opposite to the magnitude order of the radii PR1, PR2, and PR3 of the pixel electrodes AE1, AE2, and AE3. In some embodiments, the inner radii IR1, IR2, and IR3 of the light blocking patterns BMP1, BMP2, and BMP3 of the second light blocking layer BM2 may each have a size of about 9 µm, and the separation distances between the light blocking patterns BMP1, BMP2, and BMP3 and the pixel electrodes AE1, AE2, and AE3 may be in a range of about 1 µm to about 3 µm.

According to the present disclosure, the light blocking patterns BMP1, BMP2, and BMP3 of the second light blocking layer BM2 have different widths. That is, the light blocking patterns BMP1, BMP2, and BMP3 of the second light blocking layer BM2 may have the same inner radii IR1, IR2, and IR3, but may have different outer radii OR1, OR2, and OR3 and therefore different widths. The widths of the light blocking patterns BMP1, BMP2, and BMP3 may be related to the radii of the pixel electrodes AE1, AE2, and AE3. In some embodiments, in the display device 10, the size relationship of the widths of the light blocking patterns BMP1, BMP2, and BMP3 may be opposite to the size relationship of the radii of the pixel electrodes AE1, AE2, and AE3. For example, the radius of the third pixel electrode AE3 may be larger than those of the first pixel electrode AE1 and the second pixel electrode AE2, but the width of the third light blocking pattern BMP3 may be smaller than those of the first light blocking pattern BMP1 and the second light blocking pattern BMP2. The radius of the second pixel electrode AE2 may be smaller than that of the first pixel electrode AE1, but the width of the second light blocking pattern BMP2 may be larger than that of the first light blocking pattern BMP1. The radii (and thus also the diameters) of the pixel electrodes AE1, AE2, and AE3 may decreases in the order of the third pixel electrode AE3, the first pixel electrode AE1, and the second pixel electrode AE2, but the widths of the light blocking patterns BMP1, BMP2, and BMP3 may increase in the order of the third light blocking pattern BMP3, the first light blocking pattern BMP1, and the second light blocking pattern BMP2.

The light blocking patterns BMP1, BMP2, and BMP3 may have the same inner radii IR1, IR2, and IR3 but different widths, so the sizes of the outer radii OR1, OR2, and OR3 may also be different from each other. The outer radius OR3 of the third light blocking pattern BMP3 may be smaller than the outer radius OR1 of the first light blocking pattern BMP1 and the outer radius OR2 of the second light blocking pattern BMP2, and the outer radius OR1 of the first light blocking pattern BMP1 may be smaller than the outer radius OR2 of the second light blocking pattern BMP2. The magnitude order of the widths and outer radii of the light blocking patterns BMP1, BMP2, and BMP3 may be opposite to the magnitude order of the radii of the pixel electrodes AE1, AE2, and AE3.

The extent to which the pixel electrodes AE1, AE2, and AE3 are covered by the light blocking patterns BMP1, BMP2, and BMP3 at a specific viewing angle looking at the display device 10 may be correlated with the separation distances between the pixel electrodes AE1, AE2, and AE3 and the light blocking patterns BMP1, BMP2, and BMP3. In order for light not to be visually recognized when the display device 10 in the second emission mode is viewed from a specific viewing angle, all of the pixel electrodes AE1, AE2, and AE3, regardless of their type, need to be covered at the corresponding viewing angle. When the radii of the pixel electrodes AE1, AE2, and AE3 are different but the separation distances from the light blocking patterns BMP1, BMP2, and BMP3 are uniform, any one of the pixel electrodes AE1, AE2, and AE3 may be completely covered at a specific viewing angle while the other pixel electrodes AE1, AE2, and AE3 might not be covered, so that the light may be visually recognized.

For example, at a specific viewing angle, the second pixel electrode AE2, which has a relatively small radius compared to other pixel electrodes, may be covered to a relatively large extent by the light blocking patterns BMP1, BMP2, and BMP3. In this case, a relatively little amount of the light emitted from the light emitting layer disposed on the second pixel electrode AE2 of the second pixel PX2 may be visually recognized at the corresponding viewing angle. When the light emitting layer disposed on the second pixel electrode AE2 emits green light, a magenta phenomenon with an overall purple color may occur in the display screen at the corresponding viewing angle due to a lack of green light.

In addition, at a specific viewing angle, the second pixel electrode AE2 having a relatively small radius might not be covered by the light blocking patterns BMP1, BMP2, and BMP3 while the other pixel electrodes AE1 and AE3 are covered by the light blocking patterns BMP1, BMP2, and BMP3. In this case, at the corresponding viewing angle, the light emitted from the light emitting layer disposed on the second pixel electrode AE2 of the second pixel PX2 may be visually recognized. When the light emitting layer disposed on the second pixel electrode AE2 emits green light, a greenish phenomenon in which the display screen has an overall green color at the corresponding viewing angle may occur.

In consideration of this, in the display device 10, at a viewing angle at which the pixel electrode with a large radius may be covered by the light blocking pattern, in order to also cover the pixel electrode with a small radius by the light blocking pattern at a similar ratio, the separation distance therebetween may be adjusted. In the display device 10, the radii of the pixel electrodes AE1, AE2, and AE3 and the inner radii IR1, IR2, and IR3 of the light blocking patterns BMP1, BMP2, and BMP3, or the separation distances between the pixel electrodes AE1, AE2, and AE3 and the light blocking patterns BMP1, BMP2, and BMP3 may be different from each other. As described above, as the radius of the pixel electrodes AE1, AE2, and AE3 increase, the above-described separation distance may decrease. In an embodiment of the present disclosure, the separation distances between the pixel electrodes AE1, AE2, and AE3 and the light blocking patterns BMP1, BMP2, and BMP3 may be different from each other, and the differential relationship of the separation distances may be opposite to the differential relationship of the radii of the pixel electrodes AE1, AE2, and AE3.

In addition, the differential relationship of the widths of the light blocking patterns BMP1, BMP2, and BMP3 may also be opposite to the differential relationship of the radii of the pixel electrodes AE1, AE2, and AE3. For example, when the widths of the light blocking patterns BMP1, BMP2, and BMP3 are the same, the second pixel electrode AE2 having a small radius may be closer to the outer side of the light blocking pattern BMP1, BMP2, BMP3 than the third pixel electrode AE3 having a large radius. In this case, the light emitted from the light emitting layer disposed on the second pixel electrode AE2 having a small radius may be emitted more easily at a high viewing angle. In consideration of this, the width of the light blocking pattern BMP1, BMP2, BMP3 corresponding to the pixel electrode AE1, AE2, AE3 having a small radius may be designed to be larger to prevent light leakage phenomenon at a high viewing angle.

As shown in FIG. 13, the position where light L emitted at a specific emission angle from one side of the pixel electrodes AE1, AE2, and AE3 reaches the light blocking patterns BMP1, BMP2, and BMP3 may be a position spaced apart from the other side of the pixel electrodes AE1, AE2, and AE3 by a certain distance. Here, the position where the light L emitted at a specific emission angle from the small-diameter pixel electrode AE1, AE2, AE3, e.g., the second pixel electrode AE2, reaches the light blocking pattern BMP1, BMP2, BMP3 may be located further away than the position where the light L emitted from the large-diameter pixel electrode AE1, AE2, AE3, e.g., the third pixel electrode AE3, reaches the light blocking pattern BMP1, BMP2, BMP3. As described above, the separation distance between the pixel electrodes AE1, AE2, and AE3 and the light blocking patterns BMP1, BMP2, and BMP3 may be smaller for the third light blocking pattern BMP3 as opposed to the size of the pixel electrodes AE1, AE2, and AE3, so that the light L emitted from the second pixel electrode AE2 may be more likely to be emitted beyond the light blocking patterns BMP1, BMP2, and BMP3. In consideration of this, a width WB2 of the second light blocking pattern BMP2 corresponding to the second pixel electrode AE2 having a small diameter may be larger than a width WB3 of the third light blocking pattern BMP3. Accordingly, a separation distance DB3 between one side of the third pixel electrode AE3 and the outer side of the third light blocking pattern BMP3 may be smaller than a separation distance DB2 between one side of the second pixel electrode AE2 and the outer side of the second light blocking pattern BMP2. The width differential relationship of the light blocking patterns BMP1, BMP2, and BMP3 may be opposite to the diameter differential relationship of the pixel electrodes AE1, AE2, and AE3.

The display device 10, according to an embodiment of the present disclosure, may include the first light blocking layer BM1 and the second light blocking layer BM2 to control the visibility of the screen at a specific viewing angle depending on the emission mode of the display device 10. In the display device 10, by designing the separation distance between the pixel electrodes AE1, AE2, and AE3, and the first light blocking layer BM1 and the second light blocking layer BM2, the width, and the like, the screen shown to the user does not have a specific color and a light leakage phenomenon that may occur at a specific viewing angle may be prevented. The display device 10 may provide a privacy protection mode to the user by blocking visibility at a specific viewing angle.

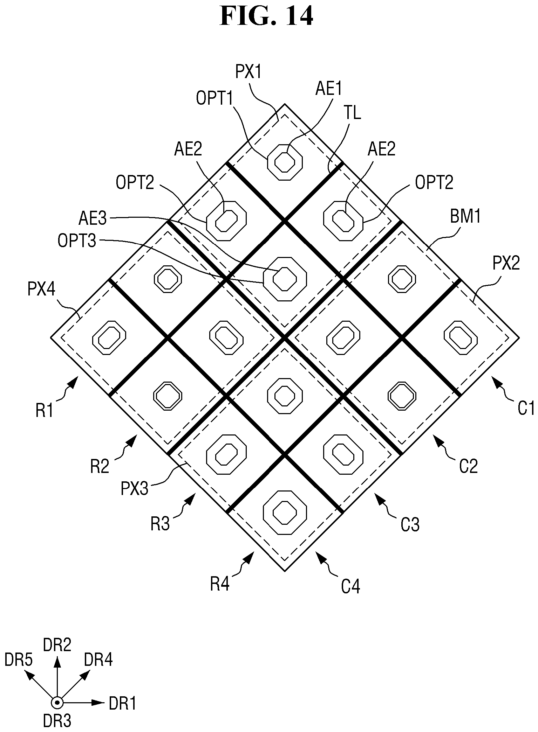

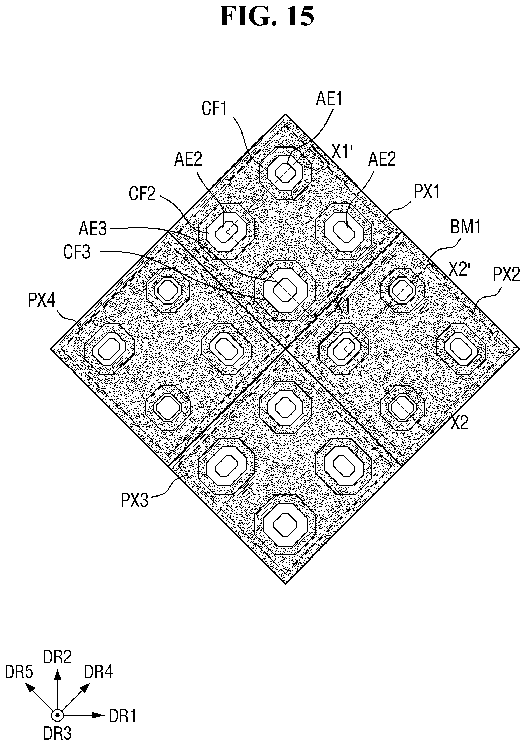

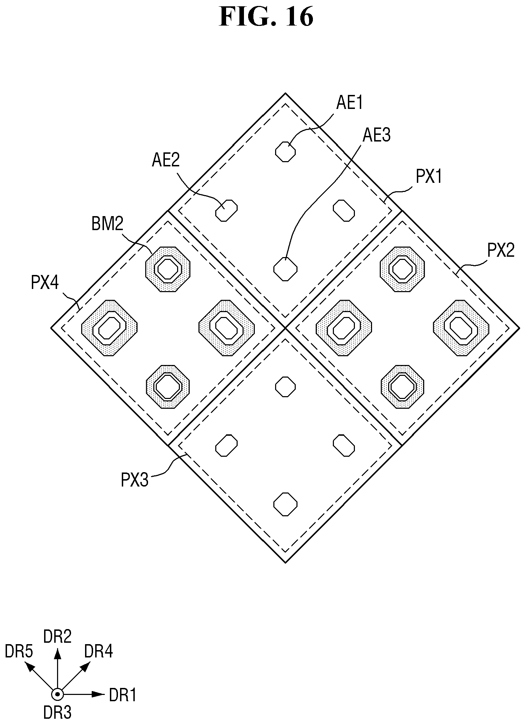

FIG. 14 is a plan view of the spatial layout of pixel electrodes in a display area of a display device according to an embodiment of the present disclosure. FIG. 15 is a plan view illustrating the spatial layout of a pixel electrode, a first light blocking layer, and color filters in a display area of the display device of FIG. 14. FIG. 16 is a plan view showing the spatial layout of a pixel electrode and a second light blocking layer in the display area of the display device of FIG. 14.

Referring to FIGS. 14 to 16, in the display device 10, according to an embodiment of the present disclosure, the pixel electrodes AE1, AE2, and AE3 may have an approximately quadrilateral shape, and accordingly, the holes OPT1, OPT2, and OPT3 of the first light blocking layer BM1 and the light blocking patterns BMP1, BMP2, and BMP3 of the second light blocking layer BM2 may also have a shape close to a quadrilateral shape. The display device 10, according to the present embodiment, is the same as that of the embodiment of FIGS. 4 to 6, except that the shapes of the pixel electrodes AE1, AE2, and AE3, the holes OPT1, OPT2, and OPT3 of the first light blocking layer BM1, and the light blocking patterns BMP1, BMP2, and BMP3 of the second light blocking layer BM2 are different.

The lengths of the first pixel electrode AE1 and the third pixel electrode AE3 measured in one direction may be the same as the lengths measured in another direction. For example, in the first pixel electrode AE1 and the third pixel electrode AE3, the length in the fourth direction DR4 having a linear side and the length in the fifth direction DR5 perpendicular thereto may be the same. The first pixel electrode AE1 and the third pixel electrode AE3 may have a substantially square or regular octagonal shape. However, as described above, the size or area of the third pixel electrode AE3 may be larger than that of the first pixel electrode AE1 in a plan view.

The length of the second pixel electrode AE2 measured in one direction may be different from the length in another direction. For example, one of the second pixel electrodes AE2 may have a length in the fourth direction DR4 that is greater than a length in the fifth direction DR5, and another of the second pixel electrodes AE2 may have a length in the fourth direction DR4 that is smaller than a length in the fifth direction DR5. Two different second pixel electrodes AE2 in one pixel PX1, PX2 may have different major axis directions.

In some embodiments, the length of the first pixel electrode AE1 measured in one direction may be the same as the length of the second pixel electrode AE2 measured in the minor axis direction, and the length of the third pixel electrode AE3 measured in one direction may be the same as the length of the second pixel electrode AE2 measured in the major axis direction. Unlike the above-described embodiment of the present disclosure, the size or area of the second pixel electrode AE2 may be larger than that of the first pixel electrode AE1 in a plan view. However, the size or area of the second pixel electrode AE2 may be smaller than that of the third pixel electrode AE3 in a plan view.

Corresponding to the shapes and sizes of the pixel electrodes AE1, AE2, and AE3, the shapes and sizes of the holes OPT1, OPT2, and OPT3 of the first light blocking layer BM1 may also be different from those of the embodiment of FIGS. 4 to 6. The holes OPT1, OPT2, and OPT3 of the first light blocking layer BM1 may also be substantially in a quadrilateral shape. However, as in the embodiment described above, the sizes of the holes OPT1, OPT2, and OPT3 of the first light blocking layer BM1 disposed in the first pixel PX1 may be larger than the sizes of the holes of the second light blocking layer BM2 disposed in the second pixel PX2, respectively.

The light blocking patterns BMP1, BMP2, and BMP3 of the second light blocking layer BM2 may surround the pixel electrodes AE1, AE2, and AE3, respectively, while being spaced apart therefrom. As described above, the separation distances between the light blocking patterns BMP1, BMP2, and BMP3 and the pixel electrodes AE1, AE2, and AE3 may vary depending on the sizes of the pixel electrodes AE1, AE2, and AE3.

In addition, in the display device 10, the widths of the light blocking patterns BMP1, BMP2, and BMP3 may also vary depending on the sizes of the pixel electrodes AE1, AE2, and AE3. According to an embodiment of the present disclosure, the display device 10 may include a pixel electrode, e.g., the second pixel electrode AE2, having different lengths measured in different directions, and the second light blocking pattern BMP2 surrounding it may have different widths depending on the position.

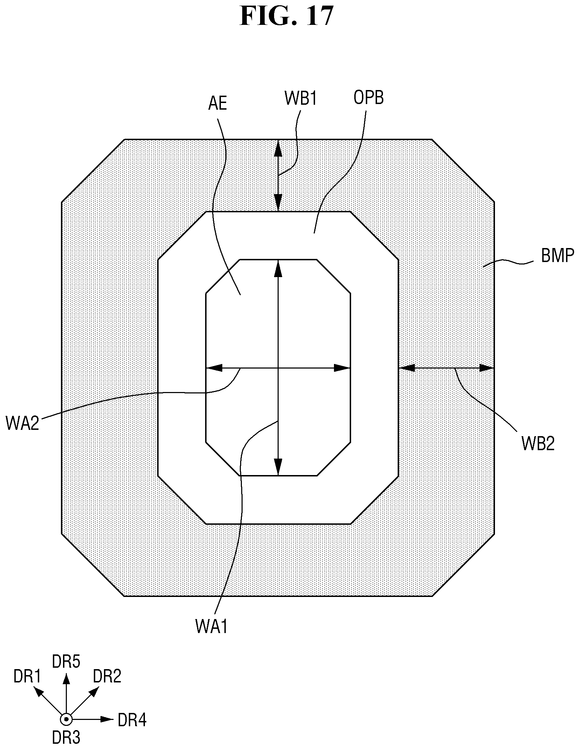

FIG. 17 is a diagram illustrating the relative position of a pixel electrode and a second light blocking layer in the display device of FIG. 14. FIG. 17 schematically illustrates the sizes of the second pixel electrode AE2 and the second light blocking pattern BMP2 in FIG. 14 to FIG. 16.

Referring to FIG. 17, in the display device 10, a first length WA1 of the pixel electrode AE (or the second pixel electrode AE2 in FIG. 14 to FIG. 16) measured in the fifth direction DR5 may be larger than a second length WA2 thereof measured in the fourth direction DR4. The light blocking pattern BMP (or the second light blocking pattern BMP2 in FIG. 16) may be spaced apart from the pixel electrode AE by a certain distance while surrounding it, and an area surrounded by the light blocking pattern BMP may be an opening OPB. As described above with reference to FIG. 13, to prevent a light leakage phenomenon at a high viewing angle, as the diameter of the pixel electrode AE decreases, the width of the light blocking pattern BMP surrounding the pixel electrode AE may increase. The light blocking pattern BMP may have one side extending in the fourth direction DR4 and another side extending in the fifth direction DR5 in the same manner as the pixel electrode AE, and a first width WB1 of the one side extending in the fourth direction DR4 may be smaller than a second width WB2 of the other side extending in the fifth direction DR5. The first length WA1 of the pixel electrode AE measured in the fifth direction DR5 may be greater than the second length WA2 thereof measured in the fourth direction DR4, and the first width WB1 of a first side of the light blocking pattern BMP disposed at a position where the long side of the pixel electrode AE extends may be smaller than the second width WB2 of a second side of the light blocking pattern BMP disposed at a position where the short side of the pixel electrode AE extends. The display device 10 may provide a privacy protection mode to the user by designing the shape and width of the light blocking pattern BMP in various ways to correspond to the shape and size of the pixel electrode AE.

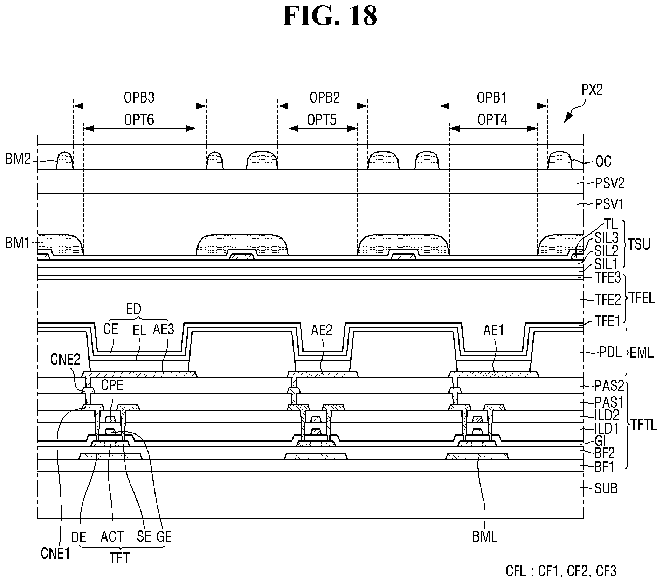

FIG. 18 is a schematic cross-sectional view of a display device according to an embodiment.

Referring to FIG. 18, in the display device 10 according to an embodiment of the present disclosure, the color filters CF1, CF2, and CF3 may be omitted. The display device 10 according to the present embodiment is the same as that of the embodiment of FIGS. 7 and 8, except that the color filters CF1, CF2, and CF3 are omitted.

A display device comprises: a display area in which a plurality of pixels comprising a plurality of pixel electrodes spaced apart from each other are disposed; a first light blocking layer disposed within the display area and comprising a plurality of holes overlapping the plurality of pixel electrodes; a plurality of color filters disposed on the first light blocking layer and respectively corresponding to the plurality of holes; and a second light blocking layer disposed on the color filter and corresponding to the pixel electrodes of some of the plurality of pixels, wherein the second light blocking layer surrounds the pixel electrodes of the some of the plurality of pixels in a plan view, and wherein the second light blocking layer comprises a plurality of light blocking patterns having different widths.

A display device may further include a substrate on which a first pixel and a second pixel, each including a plurality of pixel electrodes, are disposed. An encapsulation layer is disposed on the pixel electrodes. A first light blocking layer is disposed on the encapsulation layer and includes a plurality of holes respectively corresponding to the pixel electrodes. A plurality of color filters is disposed on the first light blocking layer and respectively corresponds to the pixel electrodes. A passivation layer is disposed on the color filters and the first light blocking layer. A second light blocking layer is disposed on the passivation layer in the second pixel and includes a plurality of light blocking patterns forming a plurality of transmission portions respectively overlapping the pixel electrodes of the second pixel. An overcoat layer is disposed on the second light blocking layer. The pixel electrodes include a first pixel electrode disposed in each of the first pixel and the second pixel, and a second pixel electrode having a smaller diameter than that of the first pixel electrode. A width of a first light blocking pattern overlapping the first pixel electrode disposed in the second pixel is smaller than a width of a second light blocking pattern overlapping the second pixel electrode disposed in the second pixel.

In an embodiment of this display device a separation distance between a first side of the first pixel electrode of the second pixel and an outer side of the first light blocking pattern may be smaller than a separation distance between a first side of the second pixel electrode of the second pixel and an outer side of the second light blocking pattern.

Preferably, a separation distance between the first side of the first pixel electrode of the second pixel and an inner side of the first light blocking pattern may be smaller than a separation distance between the first side of the second pixel electrode of the second pixel and an inner side of the second light blocking pattern.

In another embodiment of this display device, the first light blocking layer comprises a first hole overlapping the first pixel electrode disposed in the first pixel, and a second hole overlapping the first pixel electrode disposed in the second pixel, a diameter of the first pixel electrode of the first pixel is equal to a diameter of the first pixel electrode of the second pixel, and a diameter of the first hole is larger than a diameter of the second hole.

Preferably, the first light blocking layer comprises a third hole overlapping the second pixel electrode of the first pixel, and a diameter of the first hole is equal to a diameter of the third hole.

Although some example embodiments of the present disclosure have been described above, these are examples and do not necessarily limit the present disclosure. Further, the present disclosure may be changed and modified in various ways, without departing from the features of the present disclosure, by those skilled in the art. For example, the components described in the example embodiments of the present disclosure may be modified. Differences related to these modifications and applications should be construed as being within the scope of the present disclosure.

## Claims

1. A display device (10), comprising:
a display area (DA) in which a plurality of pixels (PX1, PX2, PX3, PX4) are disposed, each pixel comprising a plurality of pixel electrodes (AE1, AE2, AE3) spaced apart from each other;
a first light blocking layer (BM1) disposed within the display area and comprising a plurality of holes (OPT1, OPT2, OPT3) overlapping the plurality of pixel electrodes (AE1, AE2, AE3);
a plurality of color filters (CF1, CF2, CF3) disposed on the first light blocking layer (BM1) and each color filter of the plurality of color filters (CF1, CF2, CF3) covering one corresponding hole of the plurality of holes (OPT1, OPT2, OPT3) of the first light blocking layer (BM1); and
a second light blocking layer (BM2) disposed on the color filters (CF1, CF2, CF3) corresponding to the pixel electrodes of some of the plurality of pixels,
wherein the second light blocking layer (BM2) surrounds the pixel electrodes of the some of the plurality of pixels in a plan view, and
wherein the second light blocking layer (BM2) comprises a plurality of light blocking patterns (BMP1, BMP2, BMP3) having different widths.

2. The display device (10) of claim 1, wherein
at least one of the plurality of the pixels (PX1, PX2, PX3, PX4) comprises a first pixel electrode (AE1) and a second pixel electrode (AE2) having a smaller diameter than the first pixel electrode (AE1),
the second light blocking layer (BM2) comprises a first light blocking pattern (BMP1) corresponding to the first pixel electrode (AE1), and a second light blocking pattern (BMP2) corresponding to the second pixel electrode (AE2), and
a separation distance between an outer side of the first pixel electrode (AE1) and an inner side of the first light blocking pattern (BMP1) is different from a separation distance between an outer side of the second pixel electrode (AE2) and an inner side of the second light blocking pattern (BMP2).

3. The display device (10) of claim 2, wherein a width of the first light blocking pattern (BMP1) is smaller than a width of the second light blocking pattern (BMP2).

4. The display device (10) of one of claims 2 or 3, wherein the separation distance between the outer side of the first pixel electrode (AE1) and the inner side of the first light blocking pattern (BMP1) is smaller than the separation distance between the outer side of the second pixel electrode (AE2) and the inner side of the second light blocking pattern (BMP2).

5. The display device (10) of at least one of claims 2 to 4, wherein the separation distance between the outer side of the first pixel electrode (AE1) and the inner side of the first light blocking pattern (BMP1) is in a range from 1 µm to 3 µm.

6. The display device (10) of at least one of claims 2 to 5, wherein a distance (IR1) between a center of the first pixel electrode (AE1) and the inner side of the first light blocking pattern (BMP1) is equal to a distance (IR2) between a center of the second pixel electrode (AE2) and the inner side of the second light blocking pattern (BMP2).

7. The display device (10) of at least one of claims 2 to 6, wherein an outer radius (OR1) from a center of the first pixel electrode (AE1) to an outer side of the first light blocking pattern (BMP1) is smaller than an outer radius (OR2) from a center of the second pixel electrode (AE2) to an outer side of the second light blocking pattern (BMP2).

8. The display device (10) of at least one of claim 2 to 7, wherein
the pixel comprises a third pixel electrode (AE3) having a larger diameter than that of the first pixel electrode (AE1),
the second light blocking layer (BM2) comprises a third light blocking pattern (BMP3) corresponding to the third pixel electrode (AE3), and
a separation distance between an outer side of the third pixel electrode (AE3) and an inner side of the third light blocking pattern (BMP3) is smaller than the separation distance between the outer side of the first pixel electrode (AE1) and the inner side of the first light blocking pattern (BMP1).

9. The display device (10) of claim 8, wherein a width of the third light blocking pattern (BMP3) is smaller than a width of the first light blocking pattern (BMP1).

10. The display device (10) of claim 2, wherein
in the first pixel electrode (AE1), a length in a first direction is equal to a length in a second direction that is perpendicular to the first direction, and
in the second pixel electrode (AE2), a length in the first direction is greater than a length in the second direction.

11. The display device (10) of claim 10, wherein in the second light blocking pattern (BMP2), a length in the first direction is greater than a length in the second direction; and/or
in the second light blocking pattern (BMP2), a width of a side extending in the first direction is larger than a width of a side extending in the second direction.

12. The display device (10) of claim 1, wherein
the plurality of pixels (PX1, PX2, PX3, PX4) comprise a first pixel (PX1) in which the second light blocking layer (BM2) is not disposed, and
a second pixel (PX2) in which the light blocking patterns respectively correspond to the pixel electrodes (AE1, AE2, AE3).

13. The display device (10) of claim 12, wherein a diameter of the hole of the first light blocking layer (BM1) in the first pixel (PX1) is larger than a diameter of the hole of the first light blocking layer (BM1) in the second pixel (PX2).

14. The display device (10) of claim 13, wherein a difference between a diameter of the first pixel electrode (AE1) and the diameter of the hole of the first light blocking layer (BM1) in the first pixel (PX1) is greater than a difference between a diameter of the first pixel electrode (AE1) and the diameter of the hole of the first light blocking layer (BM1) in the second pixel (PX2).

15. The display device (10) according to one of the preceding claims, further comprising a display panel (100), the display panel (100) comprising:
a substrate (SUB) on which a first pixel (PX1) and a second pixel (PX2) of the plurality of pixels (PX1, PX2, PX3, PX4) are disposed,;
an encapsulation layer (TFEL) disposed on the pixel electrodes (AE1, AE2, AE3);
the first light blocking layer (BM1) disposed on the encapsulation layer (TFEL);
a passivation layer (PSV1, PSV2) disposed on the color filters (CF1, CF2, CF3) and the first light blocking layer (BM1);
the second light blocking layer (BM2) disposed on the passivation layer in the second pixel (PX2) and comprising the plurality of light blocking patterns (BMP1, BMP2, BMP3) forming a plurality of transmission portions respectively overlapping the pixel electrodes of the second pixel; and
an overcoat layer (OC) disposed on the second light blocking layer (BM2).
